# EUROPEAN PATENT APPLICATION

(11) **EP 4 653 954 A1**
(43) Date of publication of application: **26.11.2025**
(21) Application number: 24177643.4
(22) Date of filing: 23.05.2024
(51) Int. Cl.: G03F 7/00

(54) **METHOD FOR CALIBRATING ILLUMINATION OPTICS**

(71) Applicant: ASML Netherlands B.V., 5500 AH Veldhoven (NL); Carl Zeiss SMT GmbH, 73447 Oberkochen (DE)
(72) Inventor: GOUDZWAARD, Maurits, 5500 AH Veldhoven (NL); BAUMER, Florian, 73447 Oberkochen (DE); STEEGHS, Marco, Matheus, Louis, 5500 AH Veldhoven (NL); HARTGERS, Albertus, 5500 AH Veldhoven (NL); SZWEDOWICZ, Konrad, 5500 AH Veldhoven (NL)
(74) Representative: ASML Netherlands B.V.

(57) **Abstract**

A method for calibrating illumination optics is disclosed. The illumination optics comprises: a first optical component comprising a two-dimensional array of independently movable reflective optical elements which is arranged to receive radiation from a radiation source; and a second optical component comprising a two-dimensional array of independently movable reflective optical elements and which is arranged to receive radiation from the first optical component and to direct it to an illumination region. The method comprises at least one calibration process. Each calibration process comprises: using the first optical component to direct radiation to a subset of the optical elements of the second optical component; receiving a portion of radiation reflected by the subset of the optical elements of the second optical component; and determining, from said reflected portion of radiation, at least one quantity that is indicative of an orientation of the subset of the optical elements.

## Description

### FIELD

The present invention relates to a method for calibrating illumination optics. The illumination optics may be for use in a lithographic apparatus. It may have particular application to an extreme ultraviolet (EUV) lithographic apparatus. The present invention also relates to a lithographic method that uses illumination optics that has been calibrated using the calibration method. The present invention also relates to a computer or storage medium having instructions for carrying out the method for calibrating illumination optics. The present invention also relates to a lithographic apparatus configured to carrying out the method for calibrating illumination optics.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern from a patterning device (e.g., a mask or reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

It is desirable to provide control over various properties of a radiation beam that is used in a lithographic apparatus to project a pattern onto a substrate. For example, it is desirable to control a dose of radiation that is delivered to the substrate. Furthermore, it is desirable to provide control over the shape (i.e. the spatial distribution) of the radiation beam in a plane of the patterning device. In addition, it is desirable to provide control over the angular distribution of the radiation beam in a plane of the patterning device. The angular distribution of the radiation beam in a plane of the patterning device may be referred to as an illumination mode or pupil and this may be chosen in dependence on the pattern being imaged to increase image contrast on the substrate.

Radiation for use in a lithographic apparatus may be generated using any convenient type of radiation source. An illumination system or illumination optics may be arranged to receive the radiation from the radiation source and to deliver the radiation to the patterning device with a desired spatial and/or angular intensity distribution. The illumination optics may be configurable in a plurality of different configurations (each configuration corresponding to a different illumination mode). The illumination optics may be re-configured (i.e. changed from a first configuration to a second configuration) by moving (for example tilting) one or more mirrors of the illumination optics. It is desirable to have good control over the configuration of the illumination optics and, therefore, it may be desirable to calibrate the illumination optics.

It may be desirable to provide new methods for calibrating illumination optics (for example in a lithographic apparatus) that at least partially addresses one or more problems associated with prior art arrangements whether identified herein or otherwise.

### SUMMARY

According to a first aspect of the present disclosure there is provided a method for calibrating illumination optics, the illumination optics comprising: a first optical component comprising a two-dimensional array of independently movable reflective optical elements which is arranged to receive radiation from a radiation source; and a second optical component comprising a two-dimensional array of independently movable reflective optical elements and which is arranged to receive radiation from the first optical component and to direct it to an illumination region; the method comprising at least one calibration process, each calibration process comprising: using the first optical component to direct radiation to a subset of the optical elements of the second optical component; receiving a portion of radiation reflected by the subset of the optical elements of the second optical component; and determining, from said reflected portion of radiation, at least one quantity that is indicative of an orientation of the subset of the optical elements.

The illumination optics may form part of a lithographic apparatus.

This type of illumination optics may comprise micro-electromechanical system (MEMS) micro-mirrors and therefore may be referred to as a MEMS illumination system, or MEMS illumination optics. Such an arrangement, wherein the second optical component comprises a plurality of independently movable reflective optical elements differs from a previous design of illumination optics in which each individual mirror (sometimes referred to as a facet mirror) is fixed relative to a support structure. A MEMS illumination system is advantageous over such previous designs of illumination optics since it provides a more flexible arrangement. In particular, a MEMS illumination system can allow for different pupil fill ratios (PFR) of the illumination optics with little or no impact on a transmission of the illumination optics. The pupil fill ratio (PFR) of the illumination optics may be a ratio of a portion of the area of the second optical component than can be illuminated at the same time to the total area of the second optical component. For example, with conventional illumination systems the pupil fill ratio (PFR) can be reduced. However, this reduction in PFR is typically achieved by reducing the amount of radiation that is directed to the illumination region. As a result, with such more conventional illumination systems, a reduction in PFR typically results in a loss of transmission of the illumination system. In contrast, a MEMS illumination system has significantly more flexibility and can achieve a reduction in PFR without a reduction in transmission (or at least with significantly less reduction in transmission). This is advantageous as it may be desirable to fill a smaller area of the second optical component with as much of the radiation received by the first optical component as possible.

The method according to the first aspect allows for the orientations of individual reflective optical elements of the second optical component to be determined. Advantageously, this may allow for the second optical component to be calibrated so that drift of the orientations of the independent movable reflective optical elements of the second optical component over time can be prevented or at least reduced.

Using the first optical component to direct radiation to a subset of the optical elements of the second optical component may comprise configuring the first optical component so as to direct radiation to a subset of the optical elements of the second optical component.

Each of the independently movable reflective optical elements of the first optical component may comprise a micro-electromechanical system (MEMS) micro-mirror. Therefore, the first optical component may be considered to comprise a MEMS micro-mirror array. Each of the independently movable reflective optical elements of the second optical component may comprise a micro-electromechanical system (MEMS) micro-mirror. Therefore, the second optical component may be considered to comprise a MEMS micro-mirror array.

Some embodiments of the method according to the first aspect may comprise a plurality of calibration processes such that an orientation of substantially all of the optical elements of the second optical component can be calibrated.

The method may comprise a plurality of calibration processes. At least some of the plurality of calibration processes may comprise: using the first optical component to direct radiation to a different subset of the optical elements of the second optical component; receiving a portion of radiation reflected by that subset of the optical elements of the second optical component; and determining, from said reflected portion of radiation, at least one quantity that is indicative of an orientation of that subset of the optical elements.

At least some of the plurality of calibration processes may use substantially the same portion of the first optical component to direct radiation to different subsets of the optical elements of the second optical component.

At least some of the plurality of calibration processes may use different portions of the first optical component to direct radiation to different subsets of the optical elements of the second optical component.

The illumination optics may be such that, in use (for example during a lithographic exposure), radiation may be directed by each of a plurality of first clusters of reflective optical elements of the first optical component to the illumination region via one of a plurality of different second clusters of reflective optical elements of the second optical component to form an image of that first cluster in the illumination region. Therefore, with such embodiments, each of the first clusters of reflective optical elements can be used to calibrate a plurality of different second clusters of reflective optical elements (in successive measurements).

The method may comprise a plurality of calibration processes. At least some of the plurality of calibration processes may comprise: using the first optical component to direct radiation to the same subset of the optical elements of the second optical component when disposed in different orientations; receiving a portion of radiation reflected by that subset of the optical elements of the second optical component; and determining, from said reflected portion of radiation, at least one quantity that is indicative of an orientation of that subset of the optical elements.

In some embodiments, a plurality of different orientations of the subset of the optical elements of the second optical component maybe used. In some embodiments, the individual optical elements of the second optical component may be rotatable about two axes. For such embodiments, a plurality of different orientations of the subset of the optical elements of the second optical component maybe used for each of the two axes.

For such embodiments, the method may further comprise changing an orientation of the subset of the optical elements of the second optical component in between two sequential calibration processes using the same subset of the optical elements of the second optical component.

For example, a measurement may be made of the at least one quantity that is indicative of an orientation of the subset of the optical elements at a plurality of different orientations of the subset of the optical elements of the second optical component. In this way, a selected or expected orientation can be mapped onto an actual orientation thus enabling the orientation of the subset of the optical elements of the second optical component to be calibrated.

In some embodiments, a plurality of different orientations of the subset of the optical elements of the second optical component may be used, which result in a different position of the radiation originating from the subset of the optical elements in a direction that corresponds to a non-scanning direction of an apparatus comprising the illumination optics. For example, the illumination optics may form part of a lithographic apparatus. The lithographic apparatus may comprise a scanning lithographic apparatus (also known as a scanner).

In at least one calibration process the subset of the optical elements of the second optical component may comprise a cluster of reflective optical elements of the second optical component. The at least one quantity that is indicative of an orientation of that subset of the optical elements may be indicative of an orientation of the cluster.

As used herein a cluster of reflective optical elements is intended to mean a plurality of reflective optical elements. The plurality of reflective optical elements may be mutually adjacent. For example, the cluster may comprise a continuous block of adjacent reflective optical elements (rather than a plurality of discrete blocks of adjacent reflective optical elements).

In at least one calibration process the subset of the optical elements of the second optical component may comprise at least one single reflective optical element of the second optical component. The at least one quantity that is indicative of an orientation of that subset of the optical elements may be indicative of an orientation of the or each at least one single optical element.

At least one calibration process may further comprise: determining a value of a calibration parameter from the or each at least one quantity that is indicative of an orientation of the subset of the optical elements.

For example, the calibration parameter may be indicative of a difference between: (i) a measured angle or orientation of the subset of the optical elements (as derived from the or each at least one quantity that is indicative of an orientation of the subset of the optical elements); and (ii) an expected angle or orientation of the subset of the optical elements.

The method may further comprise: storing in memory: (a) the or each at least one quantity that is indicative of an orientation of the subset of the optical elements determined during the or each calibration process; or (b) a calibration parameter determined therefrom.

The first optical component may comprise a plurality of first clusters of reflective optical elements. The second optical component may comprise a plurality of second clusters of reflective optical elements. When the illumination optics are in use, radiation may be directed by each of the first clusters of reflective optical elements to the illumination region via one of the second clusters of reflective optical elements such that an image of each of the first clusters is formed in the illumination region such that at least some of said images at least partially overlap with at least some others of said images. The or each calibration process may comprise: only directing radiation to the illumination region from a first subset of the plurality of first clusters of reflective optical elements; and determining a position of an image of at least one of the first subset of the plurality of first clusters of reflective optical elements formed in the illumination region or a plane that is optically conjugate to the illumination region.

Such an arrangement (wherein the first optical component comprises a plurality of first clusters of reflective optical elements, the second optical component comprises a plurality of second clusters of reflective optical elements and, wherein, when the illumination optics are in use, radiation is directed by each of the first clusters of reflective optical elements to the illumination region via one of the second clusters of optical elements such that an image of each of the first clusters is formed in the illumination region such that at least some of said images at least partially overlap with at least some others of said images) is particularly advantageous as it provides a very large degree of flexibility in the spatial and angular distributions of radiation in the illumination region.

However, such an arrangement can be difficult to calibrate. A shift in the position of one of the images relative to a nominal or desired position can indicate that there is an error in the orientation of the second cluster by which the radiation from that image was directed to the illumination region. However, if there is a large number of images overlapping in the illumination region then it can be difficult to determine such a shift. Advantageously, by only directing radiation to the illumination region from a first subset of the plurality of first clusters of reflective optical elements such shifts can be determined.

With such embodiments, each of the first subset of the plurality of first clusters of reflective optical elements is effectively being used to calibrate an orientation of the second clusters of reflective optical elements that it directs radiation to.

Only directing radiation to the illumination region from a first subset of the plurality of first clusters of reflective optical element may be achieved by directing radiation received by all other reflective optical elements of the first optical component (that do not belong to the first set) elsewhere, for example to a beam dump. The radiation may be directed elsewhere either directly or via the second optical component. For example, at least some other reflective optical elements of the first optical component (that do not belong to the first set) may be configured so as not to direct radiation to the second optical component. Alternatively or in addition, the second optical component may be configured such that radiation received thereby from at least some reflective optical elements of the first optical component (that do not belong to the first set) is not directed to the illumination region.

The method may comprise a plurality of calibration processes and at least some of the plurality of calibration processes may comprise: only directing radiation to the illumination region from different subsets of the plurality of first clusters of reflective optical elements; and determining a position of an image of at least one of each subset of the plurality of first clusters of reflective optical elements formed in the illumination region or a plane that is optically conjugate to the illumination region.

The illumination optics may be such that, in use (for example during a lithographic exposure), radiation may be directed by each of the first clusters of reflective optical elements to the illumination region via one of a plurality of different second clusters of reflective optical elements to form an image of that first cluster in the illumination region. Therefore, each of the first clusters of reflective optical elements can be used to calibrate a plurality of different second clusters of reflective optical elements (in successive measurements).

The method may further comprise: forming a feature in the image of the at least one of the first subset of the plurality of first clusters of reflective optical elements; and determining a position of the feature.

For example, a feature may be formed in the image of a first cluster by only directing radiation to the illumination region from a subset of the optical elements in that first cluster. As a result, this subset of optical elements will form a dark feature in the image of that first cluster.

The method may further comprise: for at least one of the plurality of first clusters of reflective optical elements, only directing radiation to the illumination region from a first subset of the reflective optical elements of that first cluster of reflective optical elements.

The remaining reflective optical elements of that first cluster of reflective optical elements (that do not belong to the first subset) will form a dark feature in the image of that first cluster.

The determined position of an image of at least one of the first subset of the plurality of first clusters of reflective optical elements formed in the illumination region or a plane that is optically conjugate to the illumination region may comprise a position in a direction that corresponds to a non-scanning direction of an apparatus comprising the illumination optics.

For example, the illumination optics may form part of a lithographic apparatus. The lithographic apparatus may comprise a scanning lithographic apparatus (also known as a scanner).

In use, a patterning device (for example a reticle or mask) may be disposed in the illumination region. For example, during a scanning lithographic exposure, the patterning device may be moved through the illumination region in a scanning direction. An image of the patterning device may be formed on a target region of a substrate, for example using projection optics. In general, in a scanning lithographic apparatus, the illumination region may be elongate having a longer dimension and a shorter dimension. The shorter dimension may coincide with a scanning direction of the lithographic apparatus and the longer dimension may coincide with a non-scanning direction. The illumination region may be curved or straight.

Determining a position of an image of at least one of the first subset of the plurality of first clusters of reflective optical elements formed in the illumination region or a plane that is optically conjugate to the illumination region may comprise determining a spatial distribution of the radiation in the illumination region or the plane that is optically conjugate to the illumination region and determining the position therefrom.

It will be appreciated that the spatial distribution of the radiation in the illumination region or the plane that is optically conjugate thereto may be determined in a number of different ways. In general, it may use a detector.

In one embodiment, the detector may comprise a sensor array (for example a camera) that can be used to measure the spatial distribution of the radiation in the illumination region or the plane that is optically conjugate thereto. The sensor array may comprise a plurality of sensing elements (which may be referred to as pixels). The sensor array may comprise a 1-dimensional or a 2-dimensional array of sensing elements.

In one embodiment, the detector may comprise a photo-sensitive element (for example a photodiode) that can be used to measure the spatial distribution of the radiation in the illumination region or the plane that is optically conjugate thereto.

The detector may be scanned or stepped through the illumination region or the plane conjugate thereto.

At least one calibration process may further comprise: comparing the or each determined position of the image of at least one of the first subset of first clusters of reflective optical elements formed in the illumination region or a plane that is optically conjugate thereto to a nominal position of that image; and determining a change in orientation of a corresponding second cluster of reflective optical elements that will reduce a difference between the determined position of the image of at least one of the first clusters formed in the illumination region and the nominal position of that image.

The or each calibration process may comprise: using the first optical component to direct radiation to a plurality of isolated optical elements of the second optical component which, in turn, direct at least a portion of the radiation to an illumination region; determining an angular distribution of radiation that is incident on the illumination region, or a plane that is optically conjugate to the illumination region, as a function of a position in the illumination region, or the plane that is optically conjugate to the illumination region; and determining an orientation of the plurality of isolated optical elements from the dependence of the angular distribution of radiation that is incident on the illumination region, or the plane that is optically conjugate to the illumination region, on the position in the illumination region, or the plane that is optically conjugate to the illumination region.

The second optical component comprises a two-dimensional array of independently movable reflective optical elements. Directing radiation to a plurality of isolated optical elements of the second optical component is intended to mean directing radiation to a plurality of optical elements of the second optical component such that the surrounding nearest neighbours of each such illuminated, isolated optical element of the second optical component does not receive radiation.

Such an arrangement is particularly advantageous, as now discussed.

It may be desirable to calibrate the orientations of each of the individual optical elements of the second optical component. However, it may not be practical to calibrate each of the individual reflective optical elements of the second optical component sequentially if there is a significant number of individual reflective optical elements since this may take an unacceptable amount of time (and may lead to an unacceptable loss of throughput of a lithographic apparatus that uses the illumination optics). Furthermore, in use, in general, a plurality of different independently movable reflective optical elements of the second optical component may contribute radiation to each point in the illumination region. Therefore, it is difficult to simultaneously calibrate the orientation of individual reflective optical elements of the second optical component from the spatial distribution of radiation in the illumination region.

In general, each of the independently movable reflective optical elements may direct radiation to different parts of the illumination region and at different angles. The angle subtended by a given independently movable reflective optical element of the second optical component at the illumination region is dependent on an orientation of that optical element and a position in the illumination region. For a single point in the illumination region, each of the independently movable reflective optical elements will contribute to a different range of solid angle of the angular distribution of radiation that is incident on the illumination region (or a plane that is optically conjugate thereto). Since radiation is directed to a plurality of isolated optical elements of the second optical component, only a plurality of discrete ranges of solid angle are illuminated for a given position in the illumination region. Therefore, the contribution from each of the plurality of isolated optical elements to the angular distribution of radiation that is incident on the illumination region, or a plane that is optically conjugate thereto, can be distinguished for a given point in the illumination region. Furthermore, by determining a contribution to the angular distribution of radiation that is incident on the illumination region, or a plane that is optically conjugate thereto, from each of the plurality of isolated optical elements of the second optical component as a function of position in the illumination region (or the plane that is optically conjugate thereto), an orientation of that isolated optical element can be determined.

Advantageously, this allows for a plurality of the individual optical elements of the second optical component to be calibrated simultaneously during a single calibration process.

Again, using the first optical component to direct radiation to a plurality of isolated optical elements of the second optical component which, in turn, direct at least a portion of the radiation to an illumination region can be achieved by a suitable configuration of the first and/or second optical components.

Determining an angular distribution of radiation that is incident on the illumination region, or a plane that is optically conjugate to the illumination region, as a function of a position in the illumination region, or the plane that is optically conjugate to the illumination region may comprise: placing a pinhole in the illumination region, or the plane that is optically conjugate to the illumination region; and determining a spatial distribution of radiation optically downstream of the pinhole while there is relative movement between the pinhole and the illumination region.

Relative movement between the pinhole and the illumination region may be achieved by moving the pinhole across the illumination region. Additionally or alternatively, relative movement between the pinhole and the illumination region may be achieved by moving the illumination region relative to the pinhole.

The illumination region may be referred to as a field of view (or just field) and a plane of the illumination region (and any plane optically conjugate thereto) may be referred to as a field plane. The angular distribution of radiation that is incident on the illumination region (or a plane that is optically conjugate thereto) is correlated with the spatial distribution of radiation in a Fourier transform plane of a field plane. Such a plane may be referred to as a pupil plane. The angular distribution of radiation that is incident on the illumination region (or a plane that is optically conjugate thereto) may be referred to as the pupil.

The spatial distribution of radiation optically downstream of the pinhole may be determined in the far field. The spatial distribution of radiation optically downstream of the pinhole may be determined in a pupil plane or a pupil-like plane.

In use, a patterning device (for example a reticle or mask) may be disposed in the illumination region (in a field plane that may be referred to as an object plane). An image of the patterning device may be formed on a target region of a substrate (for example using projection optics). The (field) plane in which the substrate is disposed may be referred to as the image plane.

In general, the spatial distribution of radiation optically downstream of the pinhole will comprise a plurality of discrete spots, each one corresponding to a different one of the plurality of isolated optical elements. Furthermore, as the pinhole moves across the illumination region an intensity of these discrete spots will vary. As the pinhole is scanned from one edge of the illumination region to an opposite edge of the illumination region, these discrete spots will, in general, appear and then disappear at different positions. Where (i.e. at which position in the illumination region) each discrete spot appears and/or disappears (or, in general, how the intensity of each discrete spot varies as function of position in the illumination region) is dependent on the orientation of the corresponding one of the plurality of isolated optical elements.

It will be appreciated by the skilled person that by appropriate choice of an aperture size of the pinhole, a distance between the pinhole and a detector, and a resolution of the detector, a number of discrete spots can be observed simultaneously.

It will be appreciated that the spatial distribution of radiation optically downstream of the pinhole may be determined in a number of different ways. In general, it may use a detector.

In one embodiment, the detector may comprise a sensor array (for example a camera) that can be used to measure the spatial distribution of the radiation optically downstream of the pinhole. The sensor array may comprise a plurality of sensing elements (which may be referred to as pixels). The sensor array may comprise a 1-dimensional or a 2-dimensional array of sensing elements.

In one embodiment, the detector may comprise a photo-sensitive element (for example a photodiode) that can be used to measure the spatial distribution of the radiation optically downstream of the pinhole.

The detector may be scanned or stepped through a plane optically downstream of the pinhole.

The angular distribution of radiation may be determined in a plane that is optically conjugate to the illumination region, and which corresponds to an image plane of an apparatus that uses the illumination optics.

In some lithographic apparatus, a pinhole and camera arrangement that can be used to determine the angular distribution are already provided at wafer-level (in an image plane of the lithographic apparatus) for pupil measurements. Advantageously, the method may use this existing hardware meaning that the method according to the first aspect of the present disclosure can be implemented using existing hardware.

According to a second aspect of the present disclosure there is provided a lithographic method comprising: illuminating a patterning device using illumination optics; and using an imaging system, collecting patterned radiation scattered from the patterning device and projecting the patterned radiation onto a substrate so as to form an image of the patterning device on the substrate; wherein the illumination optics comprises: a first optical component comprising a two-dimensional array of independently movable reflective optical elements which is arranged to receive radiation from a radiation source; and a second optical component comprising a two-dimensional array of independently movable reflective optical elements and which is arranged to receive radiation from the first optical component and to direct it to an illumination region in which the patterning device is disposed; and wherein the illumination optics has been calibrated using the method of the first aspect of the present disclosure.

According to a third aspect of the present disclosure there is provided a computer comprising: one or more processors; and storage media, the storage media having instructions to cause the one or more processors to carrying out the method of the first aspect of the present disclosure and/or the method of the second aspect of the present disclosure.

The one or more processors may be configured to store on the storage media: (a) the or each at least one quantity that is indicative of an orientation of the subset of the optical elements determined during the or each calibration process of the method of the first aspect of the present disclosure; or (b) a calibration parameter determined therefrom.

According to a fourth aspect of the present disclosure there is provided a computer-readable medium having instructions for carrying out the method of the first aspect of the present disclosure and/or the method of the second aspect of the present disclosure.

The computer-readable medium may be a non-transitory computer-readable medium.

According to a fifth aspect of the present disclosure there is provided a lithographic apparatus or a lithographic system comprising a controller operable to: perform the method of the first aspect of the present disclosure and/or the method of the second aspect of the present disclosure; and/or carry out the instructions of the computer-readable medium of the fourth aspect of the present disclosure.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A schematically shows a generally circular portion of the field facet mirror device of a first type of illumination system of the lithographic system shown in Figure 1, showing a central obscuration portion two portions which receive radiation;
- Figure 2B shows an example shape of a field facet for the faceted field mirror device shown in Figure 2A;
- Figure 3A schematically shows a generally circular portion of the field facet mirror device of a second type of illumination system of the lithographic system shown in Figure 1, showing a central obscuration portion two portions which receive radiation, the portions which receive radiation comprising an array of individually movable reflective optical elements;
- Figure 3B the images of two first clusters of the optical elements of the field facet mirror device shown in Figure 3A, formed in an illumination region of the apparatus; also shown is a projection of a field aperture of the projection system onto the illumination region;
- Figure 3C schematically shows a pupil facet mirror device of the second type of illumination system of the lithographic system shown in Figure 1, which comprises an array of individually movable reflective optical elements;
- Figure 3D shows a second cluster of the optical elements of the pupil facet mirror device shown in Figure 3C; also shown is a beam spot (which may be an image of an intermediate focus of a radiation source) on the second cluster;
- Figure 4A shows an example of an intensity profile of a radiation beam in a scanning direction that has a generally trapezoidal shape;
- Figure 4B shows two variants of the example intensity profile shown in Figure 3A; a first variant of the example intensity profile has larger, shallower peripheral portions whereas a second variant of the example intensity profile has smaller, steeper peripheral portions;
- Figure 5 is a schematic representation of the wafer-level illumination region also showing a plurality of different scan lines in a scanning direction (the y-direction) along which a wafer-level a sensor may be scanned in order to measure a wafer-level intensity (for example a scan-integrated intensity);
- Figure 6 is a schematic illustration of a method for calibrating illumination optics according to the present disclosure;

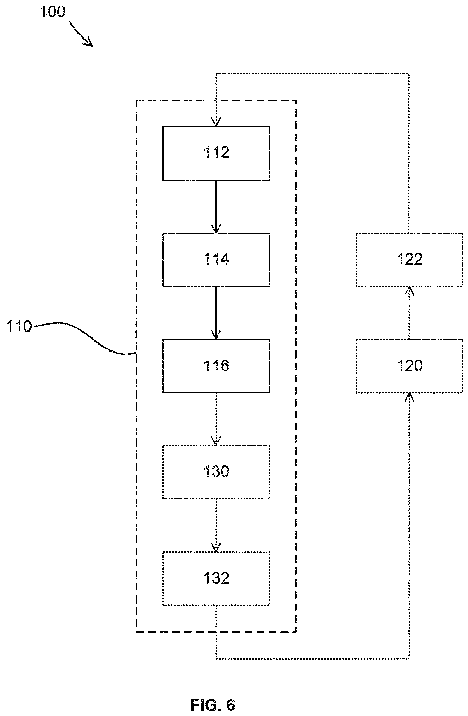

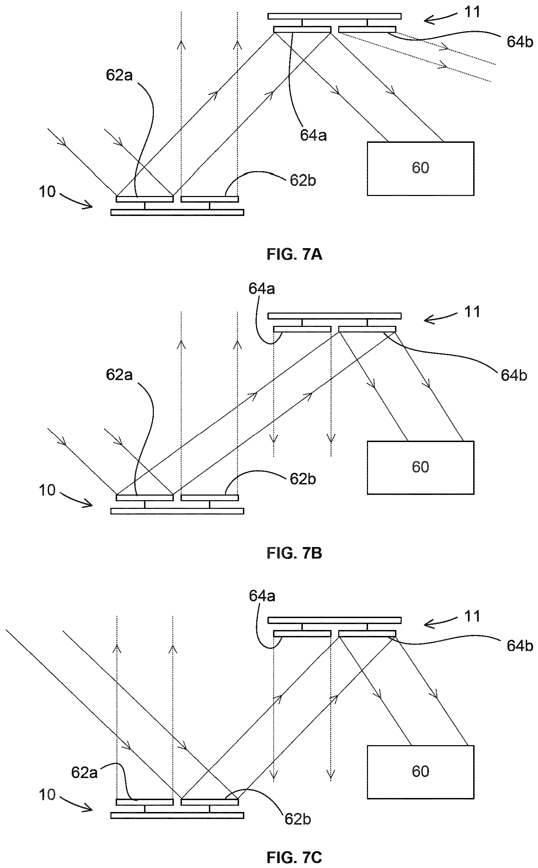

- Figures 7A to 7C schematically represent embodiments of the method shown in Figure 6 which comprise a plurality of calibration processes, wherein at least some of the plurality of calibration processes comprise: using a first optical component to direct radiation to a different subset of the optical elements of the second optical component (at step 112) and subsequently receiving a portion of radiation reflected by that subset of the optical elements of the second optical component (at step 114) from which at least one quantity that is indicative of an orientation of that subset of the optical elements is determined (at step 116); Figures 7A to 7C schematically show the first optical component, the second optical component and a measurement system; each of the Figures 7A to 7C schematically represents a different configuration of the first optical component and/or the second optical component during one of the plurality of calibration processes of the calibration method;

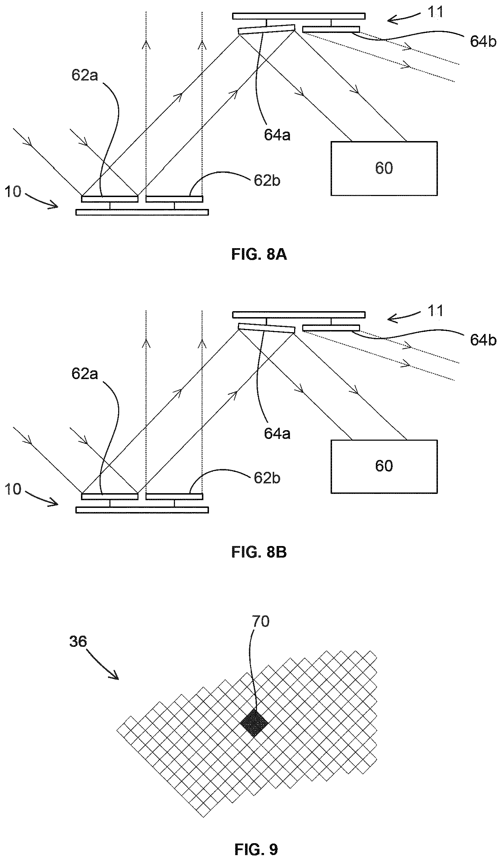

- Figures 8A and 8B schematically represent embodiments of the method shown in Figure 6 which comprise a plurality of calibration processes, wherein at least some of the plurality of calibration processes comprise: using a first optical component to direct radiation to the same subset of the optical elements of the second optical component but when disposed in different orientations (at step 112) and subsequently receiving a portion of radiation reflected by that subset of the optical elements of the second optical component (at step 114); from which at least one quantity that is indicative of an orientation of that subset of the optical elements is determined (at step 116); Figures 8A and 8B schematically show the first optical component, the second optical component and a measurement system; each of the Figures 8A and 8B schematically represents a different configuration of the first optical component and/or the second optical component during one of the plurality of calibration processes of the calibration method;
- Figure 9 schematically shows one of the example first clusters shown in Figure 3A, an image of which is formed in the (reticle-level) illumination region and wherein a feature can be formed in the image of this first cluster by directing the radiation received by a subset of the reflective optical elements of the first cluster (shaded in Figure 9) such that it is not delivered to the (reticle-level) illumination region;
- Figure 10A shows a first cluster of reflective optical elements (of a first optical component);
- Figure 10B shows an image of the first cluster shown in Figure 10A (as formed in the reticle-level illumination region);
- Figure 10C shows a slit integrated intensity of the image shown in Figure 10B (i.e. an integral of the image in the y-direction) as a function of x-position;
- Figure 11A shows a modified first cluster of reflective optical elements (of a first optical component), which is the first cluster of reflective optical elements as shown in Figure 10A with a subset of the reflective optical elements of that first clusters missing (such that a dark feature has been formed);
- Figure 11B shows an image of the modified first cluster with the dark feature as shown in Figure 11A;
- Figure 11C shows the slit integrated intensity of the image shown in Figure 11B (i.e. an integral of the image in the y-direction) as a function of x-position;
- Figures 12A to 12F show a plurality of different modified first clusters of reflective optical elements (of a first optical component), each of which is the first cluster of reflective optical elements as shown in Figure 10A with a different subset of the reflective optical elements of that first clusters missing (such that a different dark feature is formed in each of these Figures); Figures 12A to 12F also show the slit integrated intensity of an image of each of the modified first clusters;

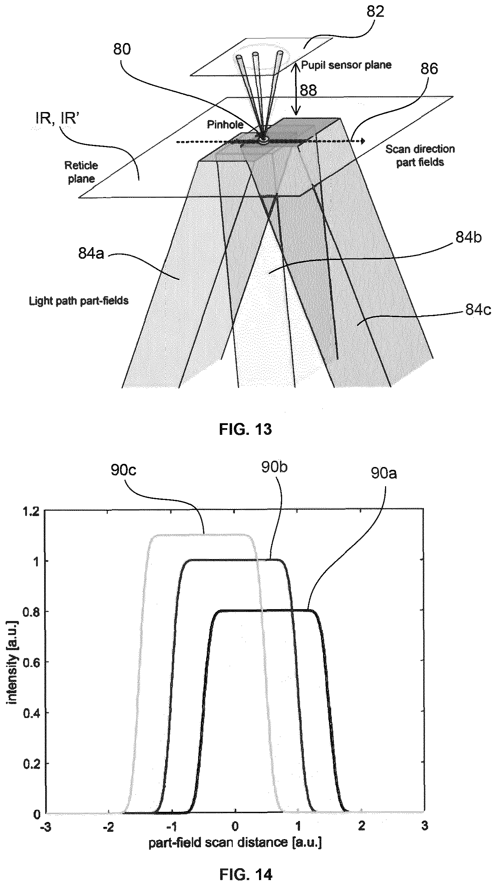

- Figure 13 schematically illustrates embodiments of the method shown in Figure 6 in which a calibration process may comprise: (at step 116) determining an angular distribution of radiation that is incident on the illumination region, or a plane that is optically conjugate to the illumination region, as a function of a position in the illumination region; as shown schematically in Figure 13, determining the angular distribution of radiation that is incident on the illumination region, or a plane that is optically conjugate thereto, as a function of a position in the illumination region, or the plane that is optically conjugate thereto may comprise: (a) placing a pinhole in the illumination region, or the plane that is optically conjugate thereto; and (b) determining a spatial distribution of radiation optically downstream of the pinhole while the pinhole relative to the illumination region (or vice versa); Figure 13 shows radiation being delivered to a field plane from three different first clusters;
- Figure 14 shows the intensity of radiation received by the pinhole shown in Figure 13 as a function of distance along a scanning trajectory (also shown in Figure 13);
- Figures 15A to 15C show the arrangement shown in Figure 13 with the pinhole disposed in three different positions relative to the field plane;

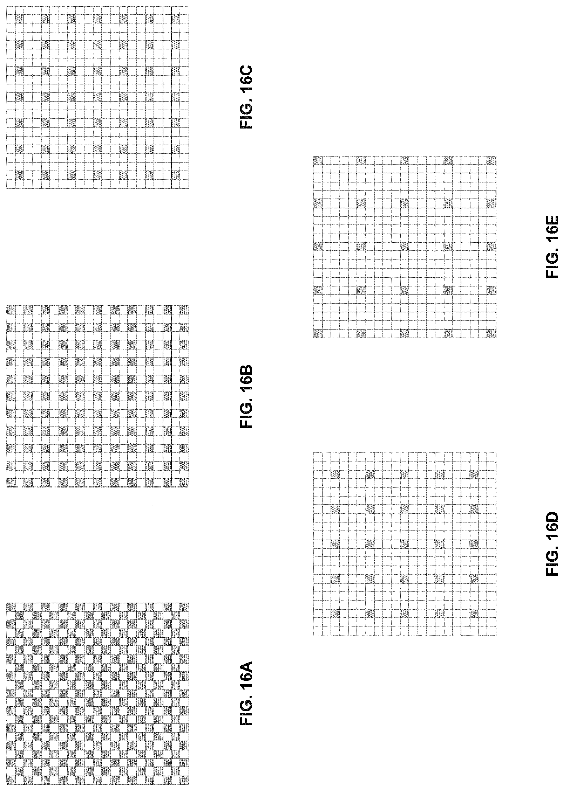

- Figures 16A to 16E schematically show a portion of a second optical component (of an illumination system) comprising an array of generally square optical elements, each showing a different subset of the optical elements that may be used in a single calibration process and which are shaded; the pupil density of each arrangement may be defined as the fraction of optical elements that are used in a single calibration process; Figure 16A shows an arrangement which uses a pupil density of 1/2; Figure 16B shows an arrangement which uses a pupil density of 1/4; Figure 16C shows an arrangement which uses a pupil density of 1/9; Figure 16D shows an arrangement which uses a pupil density of 1/16; and Figure 16E shows an arrangement which uses a pupil density of 1/25; and
- Figure 17 is a schematic illustration of a lithographic method according to an embodiment of the present disclosure, which uses illumination optics that have been calibrated using the method shown in Figure 6.

### DETAILED DESCRIPTION

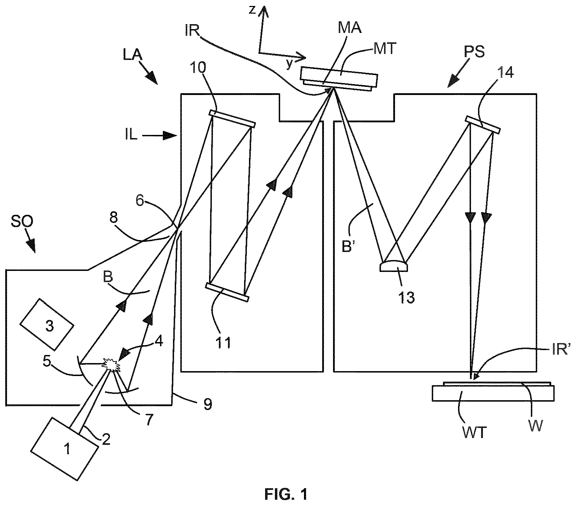

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

The faceted field mirror device 10 and the faceted pupil mirror device 11 are arranged to provide a desired angular distribution of the radiation beam B, at the patterning device MA, as well as a desired uniformity of radiation intensity at the patterning device MA. The illumination system IL may be arranged to provide Kohler illumination of an illumination region IR (that the patterning device MA may be moved through during exposure of a substrate W) such that the plasma at the plasma formation region 4 is out of focus (and therefore does not influence properties of the radiation beam) at the patterning device MA and in the conjugate plane of the substrate W. As used herein, the illumination region IR may also be referred to as the illumination slit or the slit.

In general, the illumination region IR may have a shape which generally matches a shape of a field aperture of the projection system PS (projected onto the illumination region IR). The illumination region IR may be curved or straight. In general, in a scanning lithographic apparatus LA, the illumination region IR is elongate having a longer dimension and a shorter dimension. The shorter dimension may coincide with a scanning direction of the support structure MT and the longer dimension may coincide with a non-scanning direction. The illumination region IR is indicated in Figure 1, which shows the patterning device in cross section. The longer dimension (in the x-direction) of the illumination region IR is perpendicular to the plane of Figure 1 and the shorter dimension (in the y-direction) of the illumination region IR lies in the plane of Figure 1.

The illumination region IR is in a field plane in which the reticle MA is disposed during a lithographic exposure. Therefore, the illumination region IR may be referred as a reticle-level or object-level illumination region IR. It will be appreciated that projection system PS forms an image IR' of the illumination region IR in the plane of the substrate W. The image IR' of the illumination region IR in the plane of the substrate W may be referred to as a wafer-level or image-level illumination region IR'. As used herein, the wafer-level illumination region IR' may also be referred to as the slit.

In lithography, the illumination of the patterning device MA is very important. In particular, it is desirable to control the angular distribution of the radiation at the illumination region IR where the patterning device MA is exposed to radiation. This angular distribution of the radiation is conveniently described in terms of the spatial distribution of the radiation in an illumination pupil plane, which describes how a cone of light that is incident on each point on the patterning device MA is filled. In a conventional illumination mode, the radiation uniformly fills a circular region of the illumination pupil plane centred on the optical axis such that each point on the patterning device is illuminated by a solid cone of light. In dipole illumination mode, the radiation fills two regions of the illumination pupil plane that are spaced apart from, and on opposite sides to, the optical axis. Many other illumination modes are known. In principle, an optimum illumination mode can be defined to image a given pattern under given conditions. Therefore, it is desirable to provide flexibility in the illumination mode.

The uniformity of the illumination is also very important. The uniformity of illumination affects the uniformity of dose to which the target portion of the substrate W is exposed, which affects critical dimension uniformity (CDU), an important measure of the uniformity of the dimension of features formed on the substrate W. For example, it may be desirable to maintain a desired spatial intensity distribution of radiation across the illumination region IR. As used herein the spatial intensity distribution of radiation across the illumination region IR may be referred to as the slit profile.

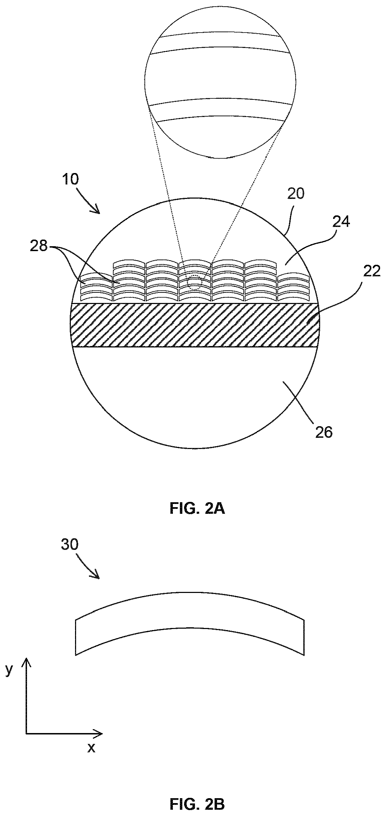

The collector 5 is generally of the form of a concave mirror, which is arranged to collect the radiation which is emitted from the plasma formation region 4 into a solid angle subtended by the collector 5. This radiation is reflected and focused at the intermediate focus 6. As a result, within the housing, the radiation beam B is generally of the form of a converging cone of radiation, which converges at the intermediate focus 6, an outer edge of this cone being indicated in Figure 1 by two lines. Downstream of the intermediate focus 6, the radiation beam B is generally of the form of a diverging cone of radiation, which is incident on the generally circular field facet mirror device 10. However, the radiation source SO may comprise an obscuration that will block a portion of this radiation cone such that there will be some portion of the diverging cone of radiation that which will not receive radiation from the collector 5. For example, the radiation source SO may comprise a shield (not shown) which may be arranged to prevent the laser beam 2 from propagating through the opening 8 and into the lithographic apparatus LA (where it may damage optical components). This shield may be supported by the enclosing structure via a support (not shown). Together, the shield and the support form an obscuration of the radiation source SO. Therefore, as indicated schematically in Figure 2A a generally circular portion 20 of the field facet mirror device 10 may comprise a central portion 22, which coincides with the obscuration of the radiation source SO and does not receive any radiation, and two portions 24, 26 which do receive radiation. It will be appreciated that this is schematic and that the obscuration may have any shape or configuration.

A first type of illumination system IL that may be used in an EUV lithographic apparatus of the type shown in Figure 1 is now described with reference to Figures 2A and 2B. In the first type of illumination system IL, the faceted field mirror device 10 comprises a plurality of field facets (which have optical power to form an image of the intermediate focus 6 at the faceted pupil mirror device 11); and the faceted pupil mirror device 11 comprises a plurality of fixed, flat pupil facets.

The faceted field mirror device 10 of the first type illumination system IL that may be used in an EUV lithographic apparatus of the type shown in Figure 1 is now described with reference to Figures 2A and 2B.

In the first type illumination system IL, the faceted field mirror device 10 comprises a plurality of field facets 28. In particular, in such EUV lithographic apparatus LA, the portions 24, 26 of the faceted field mirror device 10 that receive radiation from the radiation source SO are provided with a plurality of field facets 28. In Figure 2A, which it will be appreciated is schematic, only six rows of field facets 28 are shown in one portion 24 of the faceted field mirror device 10 that receives radiation from the radiation source SO. However, it will be appreciated that in practice substantially all of the portions 24, 26 of the faceted field mirror device 10 that receive radiation from the radiation source SO may be covered by the field facets 28. For example, the portions 24, 26 of the faceted field mirror device 10 that receive radiation from the radiation source SO may be provided with of the order of 100 field facets 28 (for example 300 field facets 28). In general, in the plane of the faceted field mirror device 10 each field facet 28 may have a shape that generally matches a shape of an illumination region IR at reticle level (which, in turn, may generally match a shape of a field aperture of the projection system PS projected onto the illumination region IR). In a plane of the faceted field mirror device 10 each field facet 28 may have a curved shape 30, as shown in Figure 2B. In general, in the plane of the faceted field mirror device 10 each field facet 28 may have an elongate shape having a longer dimension in an x-direction and a shorter dimension in a y-direction. Each field facet 28 comprises a mirror that may be arranged to image the intermediate focus 6 onto the faceted pupil mirror device 11. To achieve this, the field facets 28 may, for example, be concave.

The faceted pupil mirror device 11 of the first type illumination system IL (not shown separately in the Figures) comprises a plurality of fixed pupil facets. The faceted pupil mirror device 11 is arranged to project an image of each field facet 28 of the faceted field mirror device 10 onto an illumination region IR (also referred to as the slit or illumination slit) at the patterning device MA. The illumination system IL is configured so that each field facet 28 is imaged on the illumination region IR in an overlapping manner. The overlap of the images of the field facets 28 at least partially evens out irregularities in the intensity distribution of the radiation beam B provided by the radiation source SO.

By controlling the orientation of the individual field facets 28 of the faceted field mirror device 10, the radiation from each of the individual field facets 28 can be directed to the illumination region IR via different portions of the faceted pupil mirror device 11. In general, radiation from different parts of the faceted pupil mirror device 11 will be incident on the illumination region IR at a different range of angles. Therefore, by varying the orientation of the individual field facets 28 of the faceted field mirror device 10 an angular distribution of the radiation at the illumination region IR (also referred to as an illumination mode or pupil) may be varied.

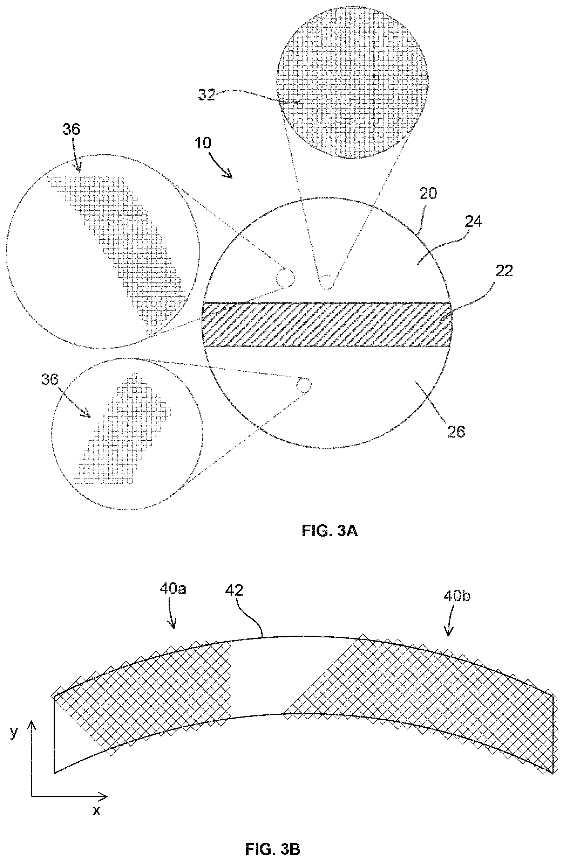

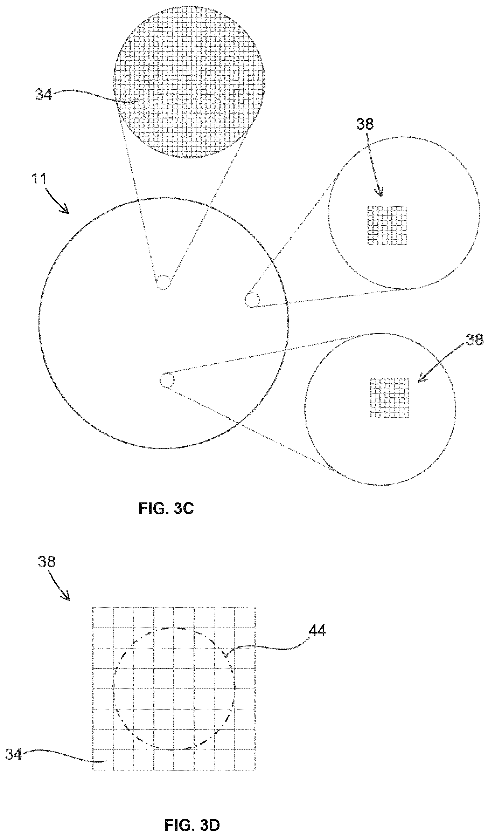

A second type illumination system IL that may be used in an EUV lithographic apparatus of the type shown in Figure 1 is now described with reference to Figures 3A to 3D. In the second type of illumination system IL, the faceted field mirror device 10 comprises a plurality of individually directable or movable reflective optical elements 32 (see Figure 3A) so as to provide control over the illumination modes of the lithographic apparatus LA. As shown in Figure 2A, Figure 3A shows a generally circular portion 20 of the field facet mirror device 10, which may comprise a central portion 22, which coincides with a obscuration of the radiation source SO and does not receive any radiation, and two portions 24, 26 which do receive radiation. It will be appreciated that this is schematic and that the obscuration may have any shape or configuration. In addition, the faceted pupil mirror device 11 comprises a plurality of individually directable or movable reflective optical elements 34 (see Figure 3C) so as to provide control over the illumination modes of the lithographic apparatus LA.

Each of the independently movable reflective optical elements 32, 34 may comprise a micro-electromechanical system (MEMS). Therefore, the faceted field mirror device 10 and/or the faceted pupil mirror device 11 may be considered to comprise a MEMS micro-mirror array.

Although Figures 2A and 3A are schematic in nature, it will be appreciated from the expanded portions of these Figures that there are significantly more of individually directable or movable reflective optical elements 32 on the faceted field mirror device 10 shown in Figure 3A than field facets 28 on the faceted field mirror device 10 shown in Figure 2A. Furthermore, the individually directable or movable reflective optical elements 32 of the faceted field mirror device 10 shown in Figure 3A are significantly smaller than field facets 28 on the faceted field mirror device 10 shown in Figure 2A.

The faceted field mirror device 10 may comprise of the order of 100,000 independently movable reflective optical elements. These reflective optical elements may substantially cover the portions 24, 26 of the faceted field mirror device 10 that receive radiation from the radiation source SO (see Figure 3A).

The individually directable or movable reflective optical elements 34 on the faceted pupil mirror device 11 of the first type illumination system IL are of a similar size to the individually directable or movable reflective optical elements 32 on the faceted field mirror device 10. Furthermore, the individually directable or movable reflective optical elements 34 on the faceted pupil mirror device 11 of the second type illumination system IL may be significantly smaller than the fixed pupil facets (nor shown separately in the Figures) of the faceted pupil mirror device 11 of the first type of illumination system IL.

Note that the second type of illumination system IL (shown schematically in Figures 3A to 3D), which may be referred to as a MEMS illumination system, differs from the first type of illumination system IL described above (with reference to Figures 2A and 2B) in that: (a) both the faceted field mirror device 10 and the faceted pupil mirror device 11 comprise a significantly larger number of individual optical elements or mirrors; and (b) the individual optical elements or mirrors 34 of the faceted pupil mirror device 11 are movable/rotatable rather than being fixed.

Since the individual mirrors 32 of the faceted field mirror device 10 shown in Figure 3A are significantly smaller than (and have a different shape to) the field facets 28 of the faceted field mirror device 10 shown in Figure 2A, the individual mirrors 32 only illuminate a relatively small portion of the illumination region IR. For example, the illumination region IR may be of the order of 1000 times the size of the individual mirrors 32 of the faceted field mirror device 10 shown in Figure 3A. For example, in one embodiment the illumination region IR may be of the order of 10 times the size of the individual mirrors 32 of the faceted field mirror device 10 shown in Figure 3A in a scanning direction (y-direction) of the lithographic apparatus and of the order of 100 times the size of the individual mirrors 32 in a non-scanning direction (x-direction) of the lithographic apparatus.

Such a MEMS illuminator (for example as described above with reference to Figures 3A to 3D) may be used as follows.

The faceted field mirror device 10 may be considered to be a first optical component 10 comprising a two-dimensional array of independently movable reflective optical elements 32 which is arranged to receive radiation B from a radiation source SO. The faceted pupil mirror device 11 may be considered to be a second optical component 11 comprising a two-dimensional array of independently movable reflective optical elements 34 and which is arranged to receive radiation from the first optical component 10 and to direct it to an illumination region IR.

The first optical component 10 may comprise a plurality of first clusters 36 of reflective optical elements 32. Similarly, the second optical component 11 may comprise a plurality of second clusters 38 of reflective optical elements 34. As used here, a cluster of reflective optical elements 32, 34 is intended to mean a plurality of reflective optical elements 32, 34. The plurality of reflective optical elements 32, 34 may be mutually adjacent. For example, the cluster may comprise a continuous block of adjacent reflective optical elements 32, 34 (rather than a plurality of discrete blocks of adjacent reflective optical elements 32, 34).

When the illumination optics are in use (i.e. when an image of a reticle MA is being formed on a wafer W), radiation is directed by each of the first clusters 36 of reflective optical elements 32 to the illumination region IR via one of the second clusters 38 of reflective optical elements 34 such that an image of each of the first clusters 36 is formed in the illumination region IR. Figure 3B schematically shows the images 40a, 40b of two such first clusters of the reflective optical elements 32 of the first optical component 10. The two first clusters which correspond to these two images 40a, 40b are also shown in two enlarged portions of the first optical component 10 in Figure 3A (for ease of understanding, in Figure 3A, reflective optical elements 32 that are adjacent these two first clusters 36 have been omitted in these two enlarged portions of the first optical component 10). Also shown is a projection 42 of the field aperture of the projection system PS onto the illumination region IR. The two example images 40a, 40b of first clusters of the reflective optical elements 32 of the first optical component 10 are shown to be not overlapping so that can be more easily distinguished.

It will be appreciated that in practice there will be a large number of such first clusters 36. For example, in general, the number of first clusters 36 will be at least as large as the number of the field facets 28 of the faceted field mirror device 10 shown in Figure 2A. In the example shown here, neither cluster image 40a, 40b fills the entire projection 42 of the field aperture of the projection system PS and, for such embodiments, the number of first clusters 36 will be larger than the number of the field facets 28 of the faceted field mirror device 10 shown in Figure 2A. In general, when the illumination optics are in use (i.e. when an image of a reticle MA is being formed on a wafer W), at least some of said images of the first clusters 36 of optical elements 32 at least partially overlap with at least some others of said images.

As stated above, when the illumination optics are in use (i.e. when an image of a reticle MA is being formed on a wafer W), radiation is directed by each of the first clusters 36 of reflective optical elements 32 to the illumination region IR via one of the second clusters 38 of reflective optical elements 34 such that an image of each of the first clusters 36 is formed in the illumination region IR. As shown schematically in Figure 3D, each first cluster 36 may form a beam spot 44 (which may be an image of the intermediate focus 6) on one of the second clusters 38. In this example, each second cluster is shown as an 8 x 8 square array of reflective optical elements 34 of the second optical component 11. However, it will be appreciated that the second clusters may have different sizes, shapes or numbers of individual reflective optical elements 34. In general, each of the first clusters 34 may be configurable such that it can deliver radiation to the illumination region IR via one of a plurality of (i.e. at least two) different second clusters 38. The angle at which the radiation is delivered to the illumination region IR from a given first cluster 36 is dependent on the second cluster 38 via which it is delivered. Therefore, by selecting a configuration of the first optical component 10 (which, effectively selects a particular set of second clusters 38 via which the radiation is delivered to the illumination region IR), different angular distributions of radiation (i.e. different illumination modes or pupils) can be selected.

In some embodiments, each second cluster 38 of reflective optical elements 34 of the second optical component 11 may be configured generally to replace one of the pupil facets (not shown) discussed above with reference to Figures 2A and 2B.

Such an arrangement (wherein the first optical component 10 comprises a plurality of first clusters 36 of reflective optical elements 32, the second optical component 11 comprises a plurality of second clusters 38 of reflective optical elements 34 and, wherein, when the illumination optics IL are in use, radiation is directed by each of the first clusters 36 of reflective optical elements 32 to the illumination region IR via one of the second clusters 38 of optical elements 34 such that an image of each of the first clusters 36 is formed in the illumination region IR such that at least some of said images at least partially overlap with at least some others of said images) is particularly advantageous as it provides a very large degree of flexibility in the spatial and angular distributions of radiation in the illumination region IR.

In some embodiments, each first cluster 36 of reflective optical elements 32 may be configured generally to replace one of the field facets 28 discussed above. For example, each first cluster 36 may cover a region of the faceted field mirror device 10 that generally corresponds to the shape of a field facet 28 of the faceted field mirror device 10 discussed above with reference to Figures 2A and 2B (for example a region having a shape generally the same as the shape 30 shown in Figure 2B). It will be appreciated that each of the reflective optical elements 32 may be generally square or rectangular in shape and therefore if the first cluster 36 is arranged as a generally curved elongate region of the faceted field mirror device 10 (similar to the shape 30 shown in Figure 2B), the shape may have jagged or pixelated edges along the curved sides of the shape. Furthermore, the orientations of the reflective optical elements 32 within each first cluster 36 may be configured so as to provide an equivalent optical power or concave shape to a field facet of an existing faceted field mirror device 10. For such embodiments, each first cluster 36 of reflective optical elements 32 (and their images formed in the illumination region IR) may have substantially the same shape.

However, note that the type of MEMS illumination system described above with reference to Figures 3A to 3D provides more freedom to deliver radiation to the illumination region IR in different ways than the illumination system discussed above with reference to Figures 2A and 2B.

Therefore, in general, the first clusters 36 of reflective optical elements 32 may have different sizes and shapes and may only illuminate a portion of the illumination region IR (as is the case for the examples shown in Figure 3B). For example, in some embodiments, each first cluster 36 of reflective optical elements 32 may cover a region of the faceted field mirror device 10 that generally corresponds to the shape of a portion of a field facet 28 of the known faceted field mirror device 10 discussed above with reference to Figures 2A and 2B.

Each of the plurality of first clusters 36 of reflective optical elements 32 may be referred to as a part field or a virtual field facet. There may be of the order of 100 or 1000 first clusters 36 of independently movable reflective optical elements 32. Each first cluster 36 of independently movable reflective optical elements 32 may comprise of the order of 100 or 1000 independently movable reflective optical elements 32.

The plurality of adj acent independently movable reflective optical elements 32 in each first cluster 36 may substantially cover a continuous region of the first optical component 10. It will be appreciated that this may mean that any gaps between adjacent reflective optical elements 32 may be minimal.

A shape of a continuous region of the first optical component 10 covered by the plurality of adjacent independently movable reflective optical elements 32 in a first cluster 36 of independently movable reflective optical elements 32 may be referred to as a shape of that first cluster 36 of independently movable reflective optical elements 32.

Each of the reflective optical elements 32, 34 (of the first optical component 10 and/or the second optical component 11) may, for example, comprise a multilayer mirror. Each of the reflective optical elements 32, 34 (of the first optical component 10 and/or the second optical component 11) may be configured such that its orientation can be controlled about one or two axes so that a direction to which it directs radiation can be controlled. For example, each of the reflective optical elements 32, 34 may have one or more actuators by which the reflective optical element can be rotated about an axis or two orthogonal axes. Thereby, each of the reflective optical elements 32, 34 can be controlled to direct radiation in a specific direction.

A reflective optical surface of the reflective optical elements 32, 34 (of the first optical component 10 and/or the second optical component 11) may be reflective for extreme ultraviolet (EUV) radiation. The reflective optical surface may comprise a multilayer mirror (also known as a Bragg mirror). The reflective optical surface may have dimensions of the order of 1 mm by 1 mm.

In some known lithographic apparatus and methods, a substrate W (for example a resist-coated silicon wafer) is exposed to patterned radiation B' during a scanning exposure process. A radiation beam B illuminates an illumination region IR (also known as "illumination slit" or just "slit") while a patterning device MA (for example a reticle) is scanned through the illumination region in a scanning direction. Typically the radiation comprises pulsed radiation. Radiation scattered from the patterning device MA is collected by imaging optics PS and projected onto a substrate W so as to form an image of the patterning device MA in a wafer-level illumination region IR' in a plane of the substrate W. The substrate W is also scanned through the wafer-level illumination region IR' so that the image is stationary with respect to the substrate W.

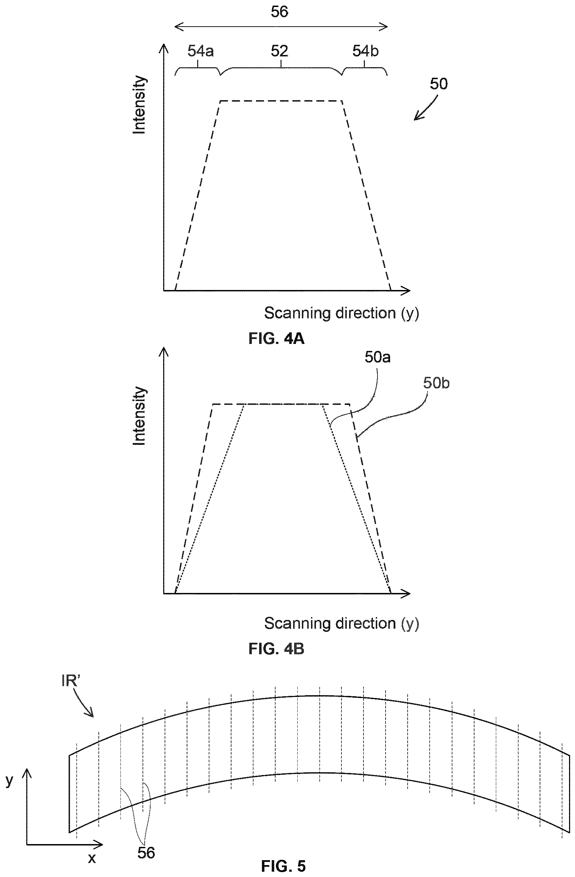

It is important for each part of the substrate W that receives radiation to receive substantially the same dose of radiation (for example to maintain critical dimension uniformity CDU). However, since the radiation beam B is pulsed, in general, not all parts of the substrate W will receive exactly the same number of pulses. Typically, the intensity profile of the radiation beam B in the scanning direction has a generally trapezoidal shape. An example of such an intensity profile 50 is shown in Figure 4A. This shape can help with accurate dose control. Furthermore, the trapezoidal shape defines the robustness of the lithographic apparatus LA dose performance to radiation source SO instabilities and energy drop outs. An intensity profile of the radiation beam B in the scanning direction with a shallower slope is more robust to source energy drop out and can improve the correctability of the die repair.

The example profile shape 50 in the scanning direction shown in Figure 4A has a generally trapezoidal shape. That is, the profile shape 50 in the scanning direction comprises a central portion 52 that is generally uniform or flat and two peripheral portions 54a, 54b. The intensity of the radiation in the peripheral portions 54a, 54b varies as a function of distance from the central portion 52 from the value of the central portion 52 to zero. A gradient, and/or extent, of the peripheral portions 54a, 54b may characterize how robust the lithographic apparatus LA is to energy variations and energy drop outs of the radiation source SO. Two variants of the example intensity profile 50a, 50b are shown in Figure 4B; a first variant of the example intensity profile 50a has larger, shallower peripheral portions 54a, 54b whereas a second variant of the example intensity profile 50b has smaller, steeper peripheral portions 54a, 54b. Larger, shallower peripheral portions 54a, 54b are more robust to energy variations and energy drop outs of the radiation source SO whereas smaller, steeper peripheral portions 54a, 54b are less robust to energy variations and energy drop outs of the radiation source SO.

It may be desirable to monitor the intensity distribution at the wafer-level illumination region IR'. In order to do this, a sensor may be provided on the substrate table WT (see Figure 1). For example, a photodiode may be provided on the substrate table WT. By moving the sensor to a plurality of different positions in the wafer-level illumination region IR' (by moving the substrate table WT) and taking a measurement at each position, the intensity distribution at the wafer-level illumination region IR' can be determined. In some systems, such a wafer-level sensor may be scanned along a plurality of different scan lines 56 in the scanning direction (the y-direction), as indicated schematically in Figure 5. During each such scan, an intensity profile of the type shown in Figures 4A and 4B may be determined. To illustrate this, an example of one such scan line 56 is indicated in Figure 4A by an arrow. Each of the scan lines 56 is disposed at a different position in the non-scanning direction (the x-direction). Therefore, an intensity profile of the type shown in Figures 4A and 4B may be determined for a plurality of different positions in the non-scanning direction (the x-direction).

A total dose of radiation received by the sensor during one of the scans along a scan line 56 may be referred to a scan-integrated intensity. The scan-integrated intensity is proportional to the integral of an intensity profile of the type shown in Figures 4A and 4B.

Some embodiments of the present disclosure relate to methods for calibrating illumination optics. In particular, they may relate to methods for calibrating illumination optics of the second type as described above with reference to Figures 3A to 3D. In particular, they may relate to methods for calibrating the second optical component 11 (the faceted pupil mirror device 11) of the second type of illumination optics described above with reference to Figures 3A to 3D.

Figure 6 is a schematic illustration of a method 100 for calibrating illumination optics according to the present disclosure. The illumination optics may form part of a lithographic apparatus LA. For example, the illumination optics may comprise the second type of illumination system IL described above with reference to Figures 3A to 3D. The illumination optics comprises: a first optical component 10 comprising a two-dimensional array of independently movable reflective optical elements 32 which is arranged to receive radiation from a radiation source SO; and a second optical component 11 comprising a two-dimensional array of independently movable reflective optical elements 34 and which is arranged to receive radiation from the first optical component 10 and to direct it to an illumination region IR.

Steps of the method 100 shown in Figure 6 that are optional are shown in dotted lines.

The method 100 comprises at least one calibration process 110.

The or each calibration process 110 comprises a step 112 of using the first optical component 10 to direct radiation to a subset of the optical elements 34 of the second optical component 11.

The or each calibration process 110 further comprises a step 114 of receiving a portion of radiation reflected by the subset of the optical elements 34 of the second optical component 11.

The or each calibration process 110 further comprises a step 116 of determining, from said reflected portion of radiation, at least one quantity that is indicative of an orientation of the subset of the optical elements 34.

As explained above, this type of illumination optics may comprise micro-electromechanical system (MEMS) micro-mirrors and therefore may be referred to as a MEMS illumination system, or MEMS illumination optics. Such an arrangement, wherein the second optical component 11 comprises a plurality of independently movable reflective optical elements 34 differs from a previous design of illumination optics in which each individual mirror (sometimes referred to as a facet mirror) is fixed relative to a support structure. A MEMS illumination system is advantageous over such previous designs of illumination optics since it provides a more flexible arrangement. In particular, a MEMS illumination system can allow for different pupil fill ratios (PFR) of the illumination optics with little or no impact on a transmission of the illumination optics. The pupil fill ratio (PFR) of the illumination optics may be a ratio of a portion of the area of the second optical component 11 than can be illuminated at the same time to the total area of the second optical component 11. For example, with conventional illumination systems (for example an illumination system of the type discussed above with reference to Figures 2A and 2B) the pupil fill ratio (PFR) can be reduced. However, this reduction in PFR is typically achieved by reducing the amount of radiation from the first optical component 10 that is directed to the illumination region IR (for example it may involve directing radiation received by a subset of the field facets 28 elsewhere). As a result, with such more conventional illumination systems, a reduction in PFR typically results in a loss of transmission of the illumination system. In contrast, a MEMS illumination system has significantly more flexibility and can achieve a reduction in PFR without a reduction in transmission. This is advantageous as it may be desirable to fill a smaller area of the second optical component 11 with as much of the radiation received by the first optical component 10 as possible.

The method 100 shown in Figure 6 allows for the orientations of individual reflective optical elements 34 of the second optical component 11 to be determined. Advantageously, this may allow for the second optical component 11 to be calibrated so that drift of the orientations of the independent movable reflective optical elements 34 of the second optical component 11 over time can be prevented or at least reduced.

Using the first optical component 10 to direct radiation to a subset of the optical elements 34 of the second optical component 11 may comprise configuring the first optical component 10 so as to direct radiation to a subset of the optical elements 34 of the second optical component 11.

Each of the independently movable reflective optical elements 32 of the first optical component 10 may comprise a micro-electromechanical system (MEMS) micro-mirror. Therefore, the first optical component 10 may be considered to comprise a MEMS micro-mirror array. Each of the independently movable reflective optical elements 34 of the second optical component 11 may comprise a micro-electromechanical system (MEMS) micro-mirror. Therefore, the second optical component 11 may be considered to comprise a MEMS micro-mirror array.

Some embodiments of the method 100 may comprise a plurality of calibration processes 110 such that an orientation of substantially all of the optical elements 34 of the second optical component 11 can be calibrated. This is indicated by the dotted arrow in Figure 6.

In some embodiments, the method 100 comprises a plurality of calibration processes 110, wherein at least some of the plurality of calibration processes comprise: using the first optical component 10 to direct radiation to a different subset of the optical elements 34 of the second optical component 11 (at step 112) and subsequently receiving a portion of radiation reflected by that subset of the optical elements 34 of the second optical component 11 (at step 114) from which at least one quantity that is indicative of an orientation of that subset of the optical elements 34 is determined (at step 116). In order to facilitate such embodiments, the method 100 may comprise a step 120 of re-configuring the first optical component 10 and/or a step 122 of re-configuring the second optical component 11 in between any two consecutive calibration processes 110 in which radiation is directed to (at step 112) and/or received from (at step 114) a different subset of the optical elements 34 of the second optical component 11. Such embodiments of the method are now discussed further with reference to Figures 7A to 7C.

Figures 7A to 7C schematically show the first optical component 10, the second optical component 11 and a measurement system 60. Also shown are two portions 62a, 62b of the first optical component 10 and two portions 64a, 64b of the second optical component 11 (it will be appreciated that only two portions of each optical component 10, 11 are shown for ease of understanding and, in practice, each optical component 10, 11 may comprise a significantly larger number of portions). The two portions 62a, 62b of the first optical component 10 may each correspond to one of the individual reflective optical elements 32 of the first optical component 10 or a first cluster 36 of such reflective optical elements 32. Similarly, the two portions 64a, 64b of the second optical component 11 may each correspond to one of the individual reflective optical elements 34 of the second optical component 11 or a second cluster 38 of such reflective optical elements 34.

Each of the Figures 7A to 7C schematically represents a configuration of the first optical component 10 and the second optical component 11 during one of the plurality of calibration processes 110 of the calibration method 100.

In Figure 7A, radiation is directed to a first portion 64a of the second optical component 11 using a first portion 62a of the first optical component 10 and a portion of radiation reflected by the first portion 64a of the second optical component 11 is received by the measurement system 60. Any radiation received by a second portion 62b of the first optical component 10 or a second portion 64b of the second optical component 11 may be directed elsewhere (for example to a beam dump).

In Figure 7B, radiation is directed to the second portion 64b of the second optical component 11 using the first portion 62a of the first optical component 10 and a portion of radiation reflected by the second portion 64b of the second optical component 11 is received by the measurement system 60. Any radiation received by the second portion 62b of the first optical component 10 or the first portion 64a of the second optical component 11 may be directed elsewhere (for example to a beam dump).

In Figure 7C, radiation is directed to the second portion 64b of the second optical component 11 using the second portion 62a of the first optical component 10 and a portion of radiation reflected by the second portion 64b of the second optical component 11 is received by the measurement system 60. Any radiation received by the first portion 62a of the first optical component 10 or the first portion 64a of the second optical component 11 may be directed elsewhere (for example to a beam dump).

In some embodiments, at least some of the plurality of calibration processes 110 use substantially the same portion of the first optical component 10 to direct radiation to different subsets of the optical elements 34 of the second optical component 11. Such embodiments may, for example, comprise a combination of the calibration processes 110 shown in Figures 7A and 7B.

Additionally or alternatively, at least some of the plurality of calibration processes 110 use different portions of the first optical component 10 to direct radiation to different subsets of the optical elements 34 of the second optical component 11. Such embodiments may, for example, comprise a combination of the calibration processes 110 shown in Figures 7A and 7C.

The illumination optics IL may be such that, in use (for example during a lithographic exposure), radiation may be directed by each of a plurality of first clusters 36 of reflective optical elements 32 of the first optical component 10 to the illumination region IR via one of a plurality of different second clusters 38 of reflective optical elements 34 of the second optical component 11 to form an image of that first cluster in the illumination region IR. Therefore, with such embodiments, each of the first clusters 36 of reflective optical elements 32 can be used to calibrate a plurality of different second clusters 38 of reflective optical elements 34 (in successive measurements).

In some embodiments, the method 100 comprises a plurality of calibration processes 110, wherein at least some of the plurality of calibration processes comprise: using the first optical component 10 to direct radiation to the same subset of the optical elements 34 of the second optical component 11 but when disposed in different orientations (at step 112) and subsequently receiving a portion of radiation reflected by that subset of the optical elements 34 of the second optical component 11 (at step 114); from which at least one quantity that is indicative of an orientation of that subset of the optical elements 34 is determined (at step 116). In order to facilitate such embodiments, the method 100 may comprise the step 122 of re-configuring the second optical component 11 in between any two consecutive calibration processes 110 in which radiation is directed to (at step 112) or received from (at step 114) the same subset of the optical elements 34 of the second optical component 11 (but when said subset are disposed in different orientations).

Such embodiments of the method are now discussed further with reference to Figures 8A and 8B.

Figures 8A and 8B are similar to Figures 7A to 7C and each schematically shows the first optical component 10 (comprising two portions 62a, 62b), the second optical component 11 (comprising two portions 64a, 64b) and a measurement system 60. Each of the Figures 8A and 8B schematically represents a configuration of the second optical component 11 during one of the plurality of calibration processes 110 of the calibration method 100.

In Figure 8A, while the first portion 64a of the second optical component 11 is disposed in a first orientation, radiation is directed to a first portion 64a of the second optical component 11 using a first portion 62a of the first optical component 10 and a portion of radiation reflected by the first portion 64a of the second optical component 11 is received by the measurement system 60. Any radiation received by a second portion 62b of the first optical component 10 or a second portion 64b of the second optical component 11 may be directed elsewhere (for example to a beam dump).

In Figure 8B, while the first portion 64a of the second optical component 11 is disposed in a second orientation, radiation is directed to a first portion 64a of the second optical component 11 using a first portion 62a of the first optical component 10 and a portion of radiation reflected by the first portion 64a of the second optical component 11 is received by the measurement system 60. Any radiation received by a second portion 62b of the first optical component 10 or a second portion 64b of the second optical component 11 may be directed elsewhere (for example to a beam dump).

In some embodiments, a plurality of different orientations of the subset of the optical elements 34 of the second optical component 11 maybe used (for example as illustrated in Figures 8A and 8B). In some embodiments, the individual optical elements 34 of the second optical component 11 may be rotatable about two axes. For such embodiments, a plurality of different orientations of the subset of the optical elements 34 of the second optical component 11 maybe used for each of the two axes.

For such embodiments, the method 100 may further comprise changing an orientation of the subset of the optical elements 34 of the second optical component 11 (at step 122) in between two sequential calibration processes 110 using the same subset of the optical elements 34 of the second optical component 11.

For example, a measurement may be made of the at least one quantity that is indicative of an orientation of the subset of the optical elements 34 at a plurality of different orientations of the subset of the optical elements 34 of the second optical component 11. In this way, a selected or expected orientation can be mapped onto an actual orientation thus enabling the orientation of the subset of the optical elements 34 of the second optical component 11 to be calibrated.

In some embodiments, a plurality of different orientations of the subset of the optical elements 34 of the second optical component 11 may be used, which result in a different position of the radiation originating from the subset of the optical elements in a direction that corresponds to a non-scanning direction of an apparatus comprising the illumination optics 10, 11. For example, the illumination optics 10, 11 may form part of a lithographic apparatus LA, which, in turn, may comprise a scanning lithographic apparatus (also known as a scanner).

In some embodiments of the method 100 in at least one calibration process 110 the subset of the optical elements 34 of the second optical component 11 may comprise at least one cluster 38 of reflective optical elements 34 of the second optical component 11 and the at least one quantity that is indicative of an orientation of that subset of the optical elements 34 may be indicative of an orientation of the cluster 38. Such embodiments are discussed further below with reference to Figures 9 to 12F.

In some embodiments of the method 100 in at least one calibration process 110 the subset of the optical elements 34 of the second optical component 11 may comprise at least one single reflective optical element 34 of the second optical component 11 and the at least one quantity that is indicative of an orientation of that subset of the optical elements 34 may be indicative of an orientation of the or each at least one single optical element 34. The at least one single reflective optical element 34 may, for example, be an isolated reflective optical element 34 (for example, its nearest neighbours may be not illuminated during that calibration process 110. Such embodiments are discussed further below with reference to Figures 13 to 16.

In some embodiments of the method 100 at least one calibration process 110 may further comprise a step 130 of determining a value of a calibration parameter from the or each at least one quantity that is indicative of an orientation of the subset of the optical elements 34. For example, the calibration parameter may be indicative of a difference between: (i) a measured angle or orientation of the subset of the optical elements 34 (as derived from the or each at least one quantity that is indicative of an orientation of the subset of the optical elements 34); and (ii) an expected angle or orientation of the subset of the optical elements 34.

In some embodiments of the method 100 at least one calibration process 110 may further comprise a step 132 of storing in memory: (a) the or each at least one quantity that is indicative of an orientation of the subset of the optical elements 34 determined during the or each calibration process 110; or (b) a calibration parameter determined therefrom (at step 130).

In some embodiments, the or each calibration process 110 may comprise (at step 112) only directing radiation to the illumination region IR from a first subset of the plurality of first clusters 36 of reflective optical elements 32. Such embodiments may comprise (at step 116) determining a position of an image of at least one of the first subset of the plurality of first clusters 36 of reflective optical elements 32 formed in the illumination region IR or a plane that is optically conjugate to the illumination region IR (for example the wafer-level illumination region IR').

Such an arrangement (which uses the second type of illumination system IL described above with reference to Figures 3A to 3D) is particularly advantageous as it provides a very large degree of flexibility in the spatial and angular distributions of radiation in the illumination region IR. However, such an arrangement can be difficult to calibrate. A shift in the position of one of the images of the first clusters 36 relative to a nominal or desired position can indicate that there is an error in the orientation of the second cluster 38 by which the radiation from that image was directed to the illumination region IR. However, if there is a large number of images overlapping in the illumination region IR then it can be difficult to determine such a shift. Advantageously, by only directing radiation to the illumination region from a first subset of the plurality of first clusters 36 of reflective optical elements 32 such shifts can be more easily determined.

With such embodiments, each of the first subset of the plurality of first clusters 36 of reflective optical elements 32 is effectively being used to calibrate an orientation of the second clusters 38 of reflective optical elements 34 that it directs radiation to.

Only directing radiation to the illumination region IR from a first subset of the plurality of first clusters 36 of reflective optical element 32 may be achieved by directing radiation received by all other reflective optical elements 32 of the first optical component 10 (that do not belong to the first set) elsewhere, for example to a beam dump. The radiation may be directed elsewhere either directly or via the second optical component 11. For example, at least some other reflective optical elements 32 of the first optical component 10 (that do not belong to the first set that are being used in a given calibration process 110) may be configured so as not to direct radiation to the second optical component 11. Alternatively or in addition, the second optical component 11 may be configured such that radiation received thereby from at least some reflective optical elements 32 of the first optical component 10 (that do not belong to the first set that are being used in a given calibration process 110) is not directed to the illumination region IR.

In some embodiments, the method 100 comprises a plurality of calibration processes 110 and at least some of the plurality of calibration processes 110 comprise: (at step 112) only directing radiation to the illumination region IR from different subsets of the plurality of first clusters 36 of reflective optical elements 32; and (at step 116) determining a position of an image of at least one of each subset of the plurality of first clusters 36 of reflective optical elements 32 formed in the illumination region IR or a plane that is optically conjugate to the illumination region IR (for example the wafer-level illumination region IR') (for example the wafer-level illumination region IR'). That is, different sets of first clusters 36 may be used during (at least some of the) different calibration processes 110.

The illumination optics IL may be such that, in use (for example during a lithographic exposure), radiation may be directed by each of the first clusters 36 of reflective optical elements 32 to the illumination region IR via one of a plurality of different second clusters 38 of reflective optical elements 34 to form an image of that first cluster 36 in the illumination region IR. Therefore, each of the first clusters 36 of reflective optical elements 32 can be used to calibrate a plurality of different second clusters 38 of reflective optical elements (in successive measurements).

Some embodiments of the method 100 shown in Figure 6 may further comprise: (at or before step 112) forming a feature in the image of the at least one of the first subset of the plurality of first clusters 36 of reflective optical elements 32; and (at step 116) determining a position of the feature. For example, a feature may be formed in the image of a first cluster 36 by only directing radiation to the illumination region IR from a subset of the optical elements 32 in that first cluster 36. As a result, this subset of optical elements will form a dark feature in the image of that first cluster 36.

In some embodiments, the method 100 shown in Figure 6 may further comprise: for at least one of the plurality of first clusters 36 of reflective optical elements 32, only directing radiation to the illumination region IR from a first subset of the reflective optical elements 32 of that first cluster 36. The remaining reflective optical elements 32 of that first cluster 36 of reflective optical elements 32 (that do not belong to the first subset) will form a dark feature in the image of that first cluster 36.

As an example, Figure 9 shows one of the example first clusters 36 shown in Figure 3A, an image 40a of which is formed in the illumination region IR (see Figure 3B). A feature can be formed in the image 40a of this first cluster 36 by directing the radiation received by a subset 70 of the reflective optical elements 32 of the first cluster 36 (the first subset are shaded in Figure 9) such that it is not delivered to the illumination region IR.

In some embodiments of the method 100 shown in Figure 6, the determined position of an image of at least one of the first subset of the plurality of first clusters 36 of reflective optical elements 32 formed in the illumination region IR or a plane IR' that is optically conjugate to the illumination region IR may comprise a position in a direction that corresponds to a non-scanning direction of an apparatus (for example lithographic apparatus LA) comprising the illumination optics (i.e. the x-direction).

For such embodiments, wherein determining a position of an image of at least one of the first subset of the plurality of first clusters 36 of reflective optical elements 32 formed in the illumination region IR or a plane that is optically conjugate to the illumination region IR (for example the wafer-level illumination region IR') may comprise determining a spatial distribution of the radiation in the illumination region IR or the plane IR' that is optically conjugate to the illumination region IR and determining the position therefrom.

It will be appreciated that the spatial distribution of the radiation in the illumination region IR or the plane that is optically conjugate thereto may be determined in a number of different ways. In general, it may use a detector.

In one embodiment, the detector may comprise a sensor array (for example a camera) that can be used to measure the spatial distribution of the radiation in the illumination region IR or the plane IR' that is optically conjugate thereto. The sensor array may comprise a plurality of sensing elements (which may be referred to as pixels). The sensor array may comprise a 1-dimensional or a 2-dimensional array of sensing elements.

In one embodiment, the detector may comprise a photo-sensitive element (for example a photodiode) that can be used to measure the spatial distribution of the radiation in the illumination region IR or the plane IR' that is optically conjugate thereto.

The detector may be scanned or stepped through the illumination region IR or the plane IR' conjugate thereto.

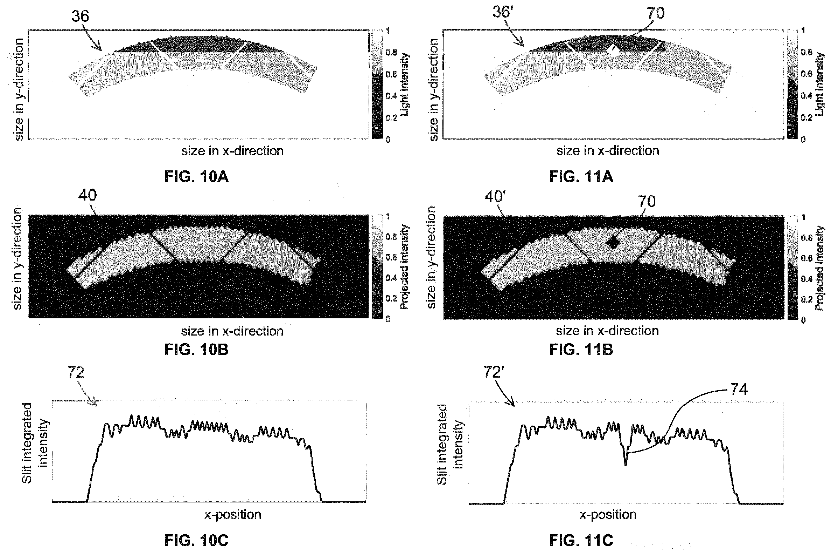

An example embodiment which involves forming a feature in the image of at least one first cluster 36 and then measuring the spatial distribution of the radiation in the illumination region IR or the plane IR' that is optically conjugate thereto to determine a position of the image is now discussed with reference to Figures 10A to 11C.

Figure 10A shows a first cluster 36 of reflective optical elements 32. An intensity of radiation received by each reflective optical elements 32 of the first cluster 36 is also shown. Figure 10B shows an image 40 of the first cluster 36 shown in Figure 10A. Again, an intensity of radiation across the image 40 is also shown. Figure 10C shows the slit integrated intensity 72 of the image 40 (i.e. an integral of the image in the y-direction) as a function of x-position. The slit integrated intensity 72 may, for example, be determined using a wafer-level sensor, as described above with reference to Figure 5.

Figure 11A shows a modified first cluster 36', which is the first cluster 36 of reflective optical elements 32 as shown in Figure 10A with a subset 70 of the reflective optical elements 32 of that first clusters 36 missing (such that a dark feature 70 has been formed). Again, an intensity of radiation received by each reflective optical elements 32 of the modified first cluster 36' is also shown. Figure 11B shows an image 40' of the modified first cluster 36' with the dark feature 70 shown in Figure 11A. Again, an intensity of radiation across the image 40' is also shown. Figure 10C shows the slit integrated intensity 72' of the image 40' (i.e. an integral of the image in the y-direction) as a function of x-position.

It can be seen from a comparison of Figures 10C and 11C that the x-position of the feature 70 can be seen as a trough 74 in the slit integrated intensity 72' of the image 40'.

In some embodiments of the method 100 shown in Figure 6, at least one calibration process 110 may further comprise: comparing the or each determined position of the image of at least one of the first clusters 36 formed in the illumination region IR to a nominal position of that image. In some embodiments of the method 100 shown in Figure 6, at least one calibration process 110 may further comprise: determining a change in orientation of a corresponding second cluster 38 of mirrors 34 that will reduce a difference in the determined position of the image of at least one of the first clusters 36 formed in the illumination region IR to a nominal position of that image.

It will be appreciated that the feature 70 (a subset of missing reflective optical elements 32 of the first cluster 36) can have various different sizes and shapes.

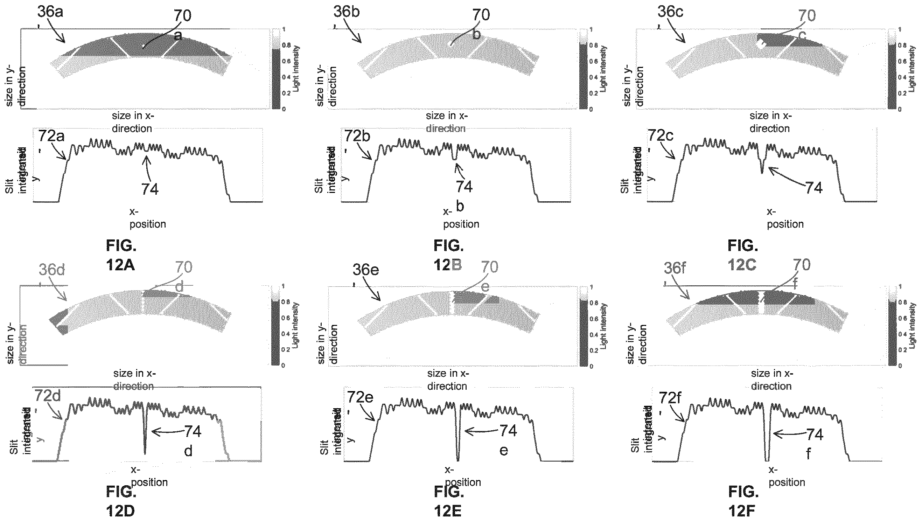

Figures 12A to 12F show modified first clusters 36a'-36f', each of which is the first cluster 36 of reflective optical elements 32 as shown in Figure 10A with a different subset 70a-70f of the reflective optical elements 32 of that first clusters 36 missing (such that a dark feature 70a-70f has been formed). Figures 12A to 12F also show the slit integrated intensity 72a'-72f' of an image 40' of each of the modified first clusters 36a' -36f'.

Some embodiments of the method 100 shown in Figure 6 which may allow for all of the optical elements 34 of the second optical component 11 to be calibrated individually are now discussed with reference to Figures 13 to 16.

In some embodiments of the method 100, the or each calibration process may comprise: (at step 112) using the first optical component 10 to direct radiation to a plurality of isolated optical elements 34 of the second optical component 11 which, in turn, direct at least a portion of the radiation to an illumination region IR. For such embodiments of the method 100, the or each calibration process may comprise: (at step 116) determining an angular distribution of radiation that is incident on the illumination region IR, or a plane IR' that is optically conjugate to the illumination region, as a function of a position in the illumination region IR, or the plane IR' that is optically conjugate to the illumination region. The or each calibration process may further comprise: (at step 116) determining an orientation of the plurality of isolated optical elements 34 from the dependence of the angular distribution of radiation that is incident on the illumination region IR, or the plane IR' that is optically conjugate to the illumination region IR, on the position in the illumination region IR, or the plane IR' that is optically conjugate to the illumination region IR.

These embodiments comprise: directing radiation to a plurality of isolated optical elements 34 of the second optical component 11 which, in turn, direct at least a portion of the radiation to an illumination region IR. As used herein, this is intended to mean directing radiation to a plurality of optical elements 34 of the second optical component 11 such that the surrounding nearest neighbours of each such illuminated, isolated optical element 34 of the second optical component does not receive radiation and/or does not direct radiation to the illumination region IR. Such an arrangement is particularly advantageous, as now discussed.

It may be desirable to calibrate the orientations of each of the individual optical elements 34 of the second optical component 11. However, it may not be practical to calibrate each of the individual reflective optical elements 34 of the second optical component 11 sequentially if there is a significant number of individual reflective optical elements 34 since this may take an unacceptable amount of time (and may lead to an unacceptable loss of throughput of a lithographic apparatus LA that uses the illumination optics IL). Furthermore, in use, in general, a plurality of different independently movable reflective optical elements 34 of the second optical component 11 may contribute radiation to each point in the illumination region IR. Therefore, it is difficult to simultaneously calibrate the orientation of individual reflective optical elements 34 of the second optical component 11 from the spatial distribution of radiation in the illumination region IR.

In general, each of the independently movable reflective optical elements 34 may direct radiation to different parts of the illumination region IR and at different angles. The angle subtended by a given independently movable reflective optical element 34 of the second optical component 11 at the illumination region IR is dependent on an orientation of that optical element and a position in the illumination region IR. For a single point in the illumination region IR, each of the independently movable reflective optical elements 34 will contribute to a different range of solid angle of the angular distribution of radiation that is incident on the illumination region IR (or a plane IR' that is optically conjugate thereto). Since radiation is directed to a plurality of isolated optical elements 34 of the second optical component 11, only a plurality of discrete ranges of solid angle are illuminated for a given position in the illumination region IR. Therefore, the contribution from each of the plurality of isolated optical elements 34 to the angular distribution of radiation that is incident on the illumination region IR, or a plane IR' that is optically conjugate thereto, can be distinguished for a given point in the illumination region IR. Furthermore, by determining a contribution to the angular distribution of radiation that is incident on the illumination region IR, or a plane IR' that is optically conjugate thereto, from each of the plurality of isolated optical elements 34 of the second optical component 11 as a function of position in the illumination region IR (or the plane IR' that is optically conjugate thereto), an orientation of that isolated optical element 34 can be determined.

Advantageously, this allows for a plurality of the individual optical elements 34 of the second optical component 11 to be calibrated simultaneously during a single calibration process 110.

Again, using the first optical component 10 to direct radiation to a plurality of isolated optical elements 34 of the second optical component 11 which, in turn, direct at least a portion of the radiation to an illumination region IR can be achieved by a suitable configuration of the first and/or second optical components 10, 11.

In some embodiments, the method 100 may comprise scanning an apparatus that samples the illumination region IR, or a plane IR' that is optically conjugate thereto, while scanning the apparatus through the illumination region IR, or a plane IR' that is optically conjugate thereto.

For example, as shown schematically in Figure 13, determining an angular distribution of radiation that is incident on the illumination region IR, or a plane IR' that is optically conjugate thereto, as a function of a position in the illumination region IR, or the plane IR' that is optically conjugate thereto may comprise: (a) placing a pinhole 80 in the illumination region IR, or the plane IR' that is optically conjugate thereto; and (b) determining a spatial distribution of radiation optically downstream of the pinhole 80 while moving the pinhole 80 across the illumination region IR, IR'.

The illumination region IR may be referred to as a field of view (or just field) and a plane of the illumination region IR (and any plane IR' optically conjugate thereto) may be referred to as a field plane. The angular distribution of radiation that is incident on the illumination region IR (or a plane that is optically conjugate thereto) is correlated with the spatial distribution of radiation in a Fourier transform plane 82 of a field plane. Such a plane may be referred to as a pupil plane 82. The angular distribution of radiation that is incident on the illumination region IR (or a plane IR' that is optically conjugate thereto) may be referred to as the pupil.

The spatial distribution of radiation optically downstream of the pinhole 80 may be determined in the far field. The spatial distribution of radiation optically downstream of the pinhole may be determined in a pupil plane 82 or a pupil-like plane.

In use, a patterning device MA (for example a reticle or mask) may be disposed in the illumination region IR (in a field plane that may be referred to as an object plane). An image of the patterning device MA may be formed on a target region of a substrate W (for example using projection optics PS). The (field) plane in which the substrate W is disposed may be referred to as the image plane.

In general, the spatial distribution of radiation optically downstream of the pinhole 80 will comprise a plurality of discrete spots, each one corresponding to a different one of the plurality of isolated optical elements 34. Furthermore, as the pinhole 80 moves across the illumination region IR an intensity of these discrete spots will vary. As the pinhole 80 is scanned from one edge of the illumination region IR to an opposite edge of the illumination region, these discrete spots will, in general, appear and then disappear at different positions. Where (i.e. at which position in the illumination region IR) each discrete spot appears and/or disappears (or, in general, how the intensity of each discrete spot varies as function of position in the illumination region IR) is dependent on the orientation of the corresponding one of the plurality of isolated optical elements 34.

Figure 13 shows radiation 84a, 84b, 84c being delivered to the field plane IR, IR' from three different first clusters 36. As discussed above, the radiation 84a, 84b, 84c from each of the different first clusters 36 is transmitted to the field plane IR, IR' via a different one of the second clusters 38. It will be appreciated that, in general, the number of first clusters 36 delivering radiation to the illumination region IR will be a significantly larger than three and that only three are shown in Figure 13 for ease of understanding. Also shown in Figure 13 is a scanning trajectory 86 of field plane IR, IR' relative to the pinhole 80. It will be appreciated that, in practice, as an alternative to scanning the field plane IR, IR' past the pinhole 80, the pinhole 80 may be moved in an opposite direction the scanning trajectory 86 across the field plane IR, IR'.

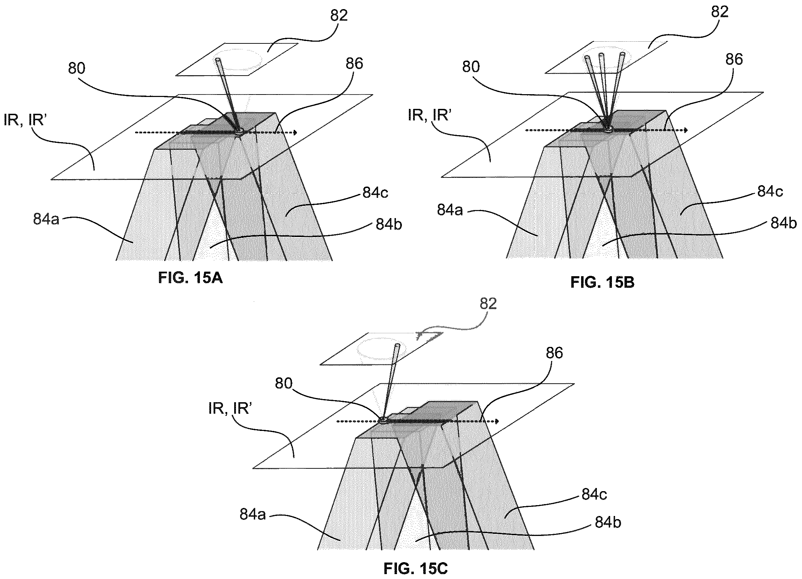

Figure 14 shows the intensities 90a, 90b, 90c of the radiation 84a, 84b, 84c received by the pinhole 80 from each of three different first clusters 36 as a function of distance (of the field plane IR, IR') along the scanning trajectory 86. In Figure 14, intensity 90a is the intensity of the radiation 84a received by the pinhole 80 from a first first cluster 36 as a function of distance along the scanning trajectory 86; intensity 90b is the intensity of the radiation 84b received by the pinhole 80 from a second first cluster 36 as a function of distance along the scanning trajectory 86; and intensity 90c is the intensity of the radiation 84c received by the pinhole 80 from a third first cluster 36 as a function of distance along the scanning trajectory 86. It will be appreciated from Figures 13 and 14 that as the field plane IR, IR' moves relative to the pinhole 80 along the scanning trajectory 86, the spatial intensity distribution in the pupil plane 82 will vary. Figures 15A to 15C show the arrangement of Figure 13 with the pinhole 80 disposed in three different positions relative to the field plane IR, IR'.

It will be appreciated by the skilled person that by appropriate choice of an aperture size of the pinhole 80, a distance 88 between the pinhole and a detector (which may be disposed in the pupil plane 82), and a resolution of the detector, a number of discrete spots can be observed (and the corresponding isolated optical elements calibrated) simultaneously.

It will be appreciated that the spatial distribution of radiation optically downstream of the pinhole 80 may be determined in a number of different ways. In general, it may use a detector.

In one embodiment, the detector may comprise a sensor array (for example a camera) that can be used to measure the spatial distribution of the radiation optically downstream of the pinhole 80. The sensor array may comprise a plurality of sensing elements (which may be referred to as pixels). The sensor array may comprise a 1-dimensional or a 2-dimensional array of sensing elements.

In one embodiment, the detector may comprise a photo-sensitive element (for example a photodiode) that can be used to measure the spatial distribution of the radiation optically downstream of the pinhole.

The detector may be scanned or stepped through a plane optically downstream of the pinhole.

In some embodiments, the angular distribution of radiation is determined in a plane IR' that is optically conjugate to the illumination region IR, and which corresponds to an image plane of an apparatus LA that uses the illumination optics IL. In some lithographic apparatus LA, a pinhole and camera arrangement that can be used to determine the angular distribution are already provided at wafer-level (in an image plane of the lithographic apparatus LA) for pupil measurements. Advantageously, the method 100 may use this existing hardware meaning that the method 100 of Figure 6 can be implemented using existing hardware.

The embodiments described above with reference to Figures 13 to 15C comprise: directing radiation to a plurality of isolated optical elements 34 of the second optical component 11 which, in turn, direct at least a portion of the radiation to an illumination region IR. As used herein, this is intended to mean directing radiation to a plurality of optical elements 34 of the second optical component 11 such that the surrounding nearest neighbours of each such illuminated, isolated optical element 34 of the second optical component does not receive radiation and/or does not direct radiation to the illumination region IR. It will be appreciated various densities of optical elements 34 of the second optical component 11 that are used for each calibration process 110 may be used which satisfy this.

Some example embodiments are shown in Figures 16A to 16E, which each schematically show a portion of the second optical component 11 comprising an array of generally square optical elements 34 and a subset of the optical elements 34 that may be used in a single calibration process 110 which are shaded. The pupil density of each arrangement may be defined as the fraction of optical elements 34 that are used in a single calibration process 110.

Figure 16A shows an arrangement which uses a pupil density of 1/2; Figure 16B shows an arrangement which uses a pupil density of 1/4; Figure 16C shows an arrangement which uses a pupil density of 1/9; Figure 16D shows an arrangement which uses a pupil density of 1/16; and Figure 16E shows an arrangement which uses a pupil density of 1/25. In general, it may be desirable to use as large a pupil density as possible (such that all of the optical elements 34 of the second optical component 11 can be calibrated in the smallest number of calibration processes 110). It will be appreciated that the pupil density should be selected to be sufficiently large such that all of the spots on the sensor or detector (in pupil plane 82) that originate from different optical elements 34 of the second optical component 11 can be resolved.

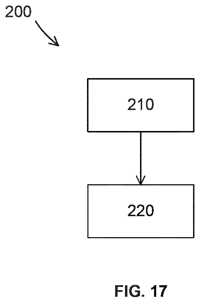

Some embodiments of the present disclosure relate to a lithographic method. The lithographic method 200 is shown schematically in Figure 17 and comprises: a step 210 of illuminating a patterning device MA using illumination optics IL; and a step 220 of, using an imaging system IL, collecting patterned radiation B' scattered from the patterning device MA and projecting the patterned radiation B' onto a substrate W so as to form an image of the patterning device MA on the substrate W.

The illumination optics is of the form of the second type of illumination system IL described above with reference to Figures 3A to 3D and comprises: a first optical component 10 comprising a two-dimensional array of independently movable reflective optical elements 32 which is arranged to receive radiation from a radiation source SO; and a second optical component 11 comprising a two-dimensional array of independently movable reflective optical elements 34 and which is arranged to receive radiation from the first optical component 10 and to direct it to an illumination region IR in which the patterning device MA is disposed.

The lithographic method 200 of Figure 17 uses illumination optics IL that has been calibrated using the method 100 shown in Figure 6 and described above.

Some embodiments of the present disclosure relate to a computer comprising: one or more processors; and storage media, the storage media having instructions to cause the one or more processors to carrying out the method 100 shown in Figure 6 and described above.

The one or more processors may be configured to store on the storage media: (a) the or each at least one quantity that is indicative of an orientation of the subset of the optical elements 34 determined during the or each calibration process 110 of the method 100 shown in Figure 6 and described above; or (b) a calibration parameter determined therefrom.

Some embodiments of the present disclosure relate to a computer-readable medium having instructions for carrying out the method 100 shown in Figure 6 and described above.

The computer-readable medium may be a non-transitory computer-readable medium.

Some embodiments of the present disclosure relate to a lithographic apparatus LA or a lithographic system comprising a controller operable to: perform the method 100 shown in Figure 6 and described above; and/or carry out the instructions for doing so from a computer-readable medium.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for calibrating illumination optics,
the illumination optics comprising: a first optical component comprising a two-dimensional array of independently movable reflective optical elements which is arranged to receive radiation from a radiation source; and a second optical component comprising a two-dimensional array of independently movable reflective optical elements and which is arranged to receive radiation from the first optical component and to direct it to an illumination region;
the method comprising at least one calibration process, each calibration process comprising:
using the first optical component to direct radiation to a subset of the optical elements of the second optical component;
receiving a portion of radiation reflected by the subset of the optical elements of the second optical component; and
determining, from said reflected portion of radiation, at least one quantity that is indicative of an orientation of the subset of the optical elements.

2. The method of claim 1 comprising a plurality of calibration processes, wherein at least some of the plurality of calibration processes comprise:
using the first optical component to direct radiation to a different subset of the optical elements of the second optical component;
receiving a portion of radiation reflected by that subset of the optical elements of the second optical component; and
determining, from said reflected portion of radiation, at least one quantity that is indicative of an orientation of that subset of the optical elements.

3. The method of claim 2 wherein at least some of the plurality of calibration processes use substantially the same portion of the first optical component to direct radiation to different subsets of the optical elements of the second optical component.

4. The method of claim 2 or claim 3 wherein at least some of the plurality of calibration processes use different portions of the first optical component to direct radiation to different subsets of the optical elements of the second optical component.

5. The method of any preceding claim, comprising a plurality of calibration processes, wherein at least some of the plurality of calibration processes comprise:
using the first optical component to direct radiation to the same subset of the optical elements of the second optical component when disposed in different orientations;
receiving a portion of radiation reflected by that subset of the optical elements of the second optical component; and
determining, from said reflected portion of radiation, at least one quantity that is indicative of an orientation of that subset of the optical elements.

6. The method of any preceding claim wherein in at least one calibration process the subset of the optical elements of the second optical component comprises a cluster of reflective optical elements of the second optical component and wherein the at least one quantity that is indicative of an orientation of that subset of the optical elements is indicative of an orientation of the cluster.

7. The method of any preceding claim wherein in at least one calibration process the subset of the optical elements of the second optical component comprises at least one single reflective optical element of the second optical component and wherein the at least one quantity that is indicative of an orientation of that subset of the optical elements is indicative of an orientation of the or each at least one single optical element.

8. The method of any preceding claim wherein at least one calibration process further comprises:
determining a value of a calibration parameter from the or each at least one quantity that is indicative of an orientation of the subset of the optical elements.

9. The method of any preceding claim further comprising:
storing in memory: (a) the or each at least one quantity that is indicative of an orientation of the subset of the optical elements determined during the or each calibration process; or (b) a calibration parameter determined therefrom.

10. The method of any preceding claim, wherein the first optical component comprises a plurality of first clusters of reflective optical elements, the second optical component comprises a plurality of second clusters of reflective optical elements and, wherein, when the illumination optics are in use, radiation is directed by each of the first clusters of reflective optical elements to the illumination region via one of the second clusters of reflective optical elements such that an image of each of the first clusters is formed in the illumination region such that at least some of said images at least partially overlap with at least some others of said images; and
wherein the or each calibration process comprises:
only directing radiation to the illumination region from a first subset of the plurality of first clusters of reflective optical elements; and
determining a position of an image of at least one of the first subset of the plurality of first clusters of reflective optical elements formed in the illumination region or a plane that is optically conjugate to the illumination region.

11. The method of claim 10 comprising a plurality of calibration processes, wherein at least some of the plurality of calibration processes comprise:
only directing radiation to the illumination region from different subsets of the plurality of first clusters of reflective optical elements; and
determining a position of an image of at least one of each subset of the plurality of first clusters of reflective optical elements formed in the illumination region or a plane that is optically conjugate to the illumination region.

12. The method of claim 10 or claim 11 further comprising:
forming a feature in the image of the at least one of the first subset of the plurality of first clusters of reflective optical elements; and
determining a position of the feature.

13. The method of any one of claims 10 to 12 further comprising:
for at least one of the plurality of first clusters of reflective optical elements, only directing radiation to the illumination region from a first subset of the reflective optical elements of that first cluster of reflective optical elements.

14. The method of any one of claims 10 to 13 wherein the determined position of an image of at least one of the first subset of the plurality of first clusters of reflective optical elements formed in the illumination region or a plane that is optically conjugate to the illumination region comprises a position in a direction that corresponds to a non-scanning direction of an apparatus comprising the illumination optics.

15. The method of any one of claims 10 to 14 wherein determining a position of an image of at least one of the first subset of the plurality of first clusters of reflective optical elements formed in the illumination region or a plane that is optically conjugate to the illumination region comprises determining a spatial distribution of the radiation in the illumination region or the plane that is optically conjugate to the illumination region and determining the position therefrom.

16. The method of any one of claims 10 to 15 wherein at least one calibration process further comprises:
comparing the or each determined position of the image of at least one of the first subset of first clusters of reflective optical elements formed in the illumination region or a plane that is optically conjugate thereto to a nominal position of that image; and
determining a change in orientation of a corresponding second cluster of reflective optical elements that will reduce a difference between the determined position of the image of at least one of the first clusters formed in the illumination region and the nominal position of that image.

17. The method of any preceding claim wherein the or each calibration process comprises:
using the first optical component to direct radiation to a plurality of isolated optical elements of the second optical component which, in turn, direct at least a portion of the radiation to an illumination region;
determining an angular distribution of radiation that is incident on the illumination region, or a plane that is optically conjugate to the illumination region, as a function of a position in the illumination region, or the plane that is optically conjugate to the illumination region; and
determining an orientation of the plurality of isolated optical elements from the dependence of the angular distribution of radiation that is incident on the illumination region, or the plane that is optically conjugate to the illumination region, on the position in the illumination region, or the plane that is optically conjugate to the illumination region.

18. The method of claim 17 wherein determining an angular distribution of radiation that is incident on the illumination region, or a plane that is optically conjugate to the illumination region, as a function of a position in the illumination region, or the plane that is optically conjugate to the illumination region comprises:
placing a pinhole in the illumination region, or the plane that is optically conjugate to the illumination region; and
determining a spatial distribution of radiation optically downstream of the pinhole while there is relative movement between the pinhole and the illumination region.

19. The method of claim 17 or claim 18 wherein the angular distribution of radiation is determined in a plane that is optically conjugate to the illumination region, and which corresponds to an image plane of an apparatus that uses the illumination optics.

20. A lithographic method comprising:
illuminating a patterning device using illumination optics; and
using an imaging system, collecting patterned radiation scattered from the patterning device and projecting the patterned radiation onto a substrate so as to form an image of the patterning device on the substrate;
wherein the illumination optics comprises: a first optical component comprising a two-dimensional array of independently movable reflective optical elements which is arranged to receive radiation from a radiation source; and a second optical component comprising a two-dimensional array of independently movable reflective optical elements and which is arranged to receive radiation from the first optical component and to direct it to an illumination region in which the patterning device is disposed; and
wherein the illumination optics has been calibrated using the method of any preceding claim.

21. A computer comprising:
one or more processors; and
storage media, the storage media having instructions to cause the one or more processors to carrying out the method of any one of claims 1 to 20.

22. The computer of claim 21 wherein the one or more processors are configured to store on the storage media:
(a) the or each at least one quantity that is indicative of an orientation of the subset of the optical elements determined during the or each calibration process of the method of any one of claims 1 to 19; or (b) a calibration parameter determined therefrom.

23. A computer-readable medium having instructions for carrying out the method of any one of claims 1 to 20.

24. A lithographic apparatus or a lithographic system comprising a controller operable to:
perform the method according to any one of claims 1 to 20; and/or
carry out the instructions of the computer-readable medium of claim 23.
